(19) Europäisches Patentamt
European Patent Office
Office européen des brevets

(11) **EP 3 076 544 B1**

(12) **EUROPÄISCHE PATENTSCHRIFT**

(45) Veröffentlichungstag und Bekanntmachung des Hinweises auf die Patenterteilung:
**15.01.2020 Patentblatt 2020/03**

(51) Int Cl.:
*H03F 1/02* *(2006.01)*    *H03F 3/217* *(2006.01)*

(21) Anmeldenummer: **15161959.0**

(22) Anmeldetag: **31.03.2015**

(54) **VERFAHREN ZUM VERSTÄRKEN EINES EINGANGSSIGNALS**

METHOD FOR AMPLIFYING AN INPUT SIGNAL

PROCÉDÉ D'AMPLIFICATION D'UN SIGNAL D'ENTRÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**05.10.2016 Patentblatt 2016/40**

(73) Patentinhaber: **Fraunhofer-Gesellschaft zur Förderung der angewandten Forschung e.V.
80686 München (DE)**

(72) Erfinder:
• **Nguyen, Hung-Anh
10717 Berlin (DE)**
• **Keusgen, Wilhelm
14089 Berlin (DE)**

(74) Vertreter: **Zimmermann, Tankred Klaus et al
Schoppe, Zimmermann, Stöckeler
Zinkler, Schenk & Partner mbB
Patentanwälte
Radlkoferstrasse 2
81373 München (DE)**

(56) Entgegenhaltungen:
**EP-A1- 2 498 397    WO-A2-2005/020430**

# EP 3 076 544 B1

**Beschreibung**

Die vorliegende Erfindung betrifft eine Vorrichtung zum Verstärken eines Eingangssignals sowie ein Verfahren zum Verstärken eines Eingangssignals.

Auf dem Gebiet der Elektronik, und insbesondere im Bereich der drahtlosen Kommunikation, gibt es viele Anwendungen in denen Bandpass-Signale generiert und verstärkt werden müssen. Ein Bandpass-Signal ist ein elektrisches Signal, dessen Spektralenergie auf eine bestimmte Bandbreite um eine Trägerfrequenz begrenzt ist. Ein Bandpass-Signal hat keine DC-Komponente und keine Spektralkomponenten oberhalb einer bestimmten Grenzfrequenz. Die Bandbreite weist typischerweise einen bestimmten prozentualen Anteil der Trägerfrequenz auf.

In den meisten Anwendungen wird ein Bandpass-Signal mit Hilfe digitaler Signalverarbeitung erzeugt, wobei die Signale als komplexwertige digitale Basisbandsignale dargestellt werden. Ein digitales Basisbandsignal hat zwei Komponenten. Einen Realteil und einen Imaginärteil, beziehungsweise eine I- und eine Q-Komponente. Üblicherweise werden die digitalen I- und Q-Signale in reellwertige analoge Tiefpass-Signale gewandelt und mit einem IQ-Mixer oder mit einem Vektormodulator, der mit einem harmonischen Signal einer Trägerfrequenz betrieben wird, in die Bandpass-Domäne überführt. Demnach kann der IQ-Mixer als ein Frequenzwandler angesehen werden, und seine Funktion als Frequenzumwandlung.

Generell hat ein Bandpass-Signal eine nicht-konstante Hüllkurve, bestimmt durch das Spitze-Mittelwert-Verhältnis. In vielen Fällen muss das Bandpass-Signal mit Hilfe einer Verstärker-Vorrichtung verstärkt werden.

Ein Leistungsverstärker ist eine Vorrichtung mit zwei Anschlüssen, mit einem Anschluss für das Eingangssignal und einem Anschluss für das Ausgangssignal. Es wird eine Hilfs-Leistungsquelle genutzt, um ein Ausgangssignal mit höherer Leistung im Vergleich zum Eingangssignal zu erzeugen.

Ein Verstärker wird mit Hilfe von Verstärker-Vorrichtungen, wie Transistoren oder Röhren realisiert. Diese Verstärker-Vorrichtungen sind in der Regel nicht-linear. In den meisten technischen Anwendungen wie zum Beispiel bei der drahtlosen Kommunikation, muss eine nicht-lineare Verzerrung des Ausgang-Signals jedoch vermieden werden, da diese Verzerrungen ungewollte Emissionen außerhalb sowie Verzerrungen innerhalb des Frequenzbands erzeugen.

Ein nahezu perfektes lineares Verhalten wird erreicht, indem das Verstärker-Element mit kleinen Signalamplituden im Vergleich zu der für dieses Element maximal zulässigen Amplitude betrieben wird. Eine Erhöhung der Eingangssignalamplitude resultiert in einer weiteren Erhöhung des nicht-linearen Verhaltens, wobei die größten Signalwerte in dem Ausgangssignal etwas komprimiert werden. Das Ausgangssignal hat jedoch immer noch einen veränderlichen Wert und der Verstärker kann als schwach nicht-linear bezeichnet werden.

Im Gegensatz dazu führt ein stark nicht-lineares Verhalten zu einer fest begrenzten Amplitude des Ausgangssignals, welches konstant und unabhängig von der Eingangsgröße ist. Ein derartiges Signal hat lediglich zwei Zustände, die mit der SignumFunktion des Eingangssignals korrespondieren, und wird im Folgenden als Binärsignal bezeichnet.

Beispiele von Verstärkern, die nahezu keine oder nur schwache nicht-Linearität aufweisen sind Klasse A oder Klasse B Verstärker. Beispiele für stark nicht-lineare Verstärker sind Klasse D und Klasse E Verstärker, wie digitale Leitungstreiber und Impulsverstärker. Diese streng nicht-linearen Verstärker werden im Folgenden als Schaltverstärker bezeichnet, da der Verstärker im Wesentlichen wie eine Schaltstromquelle agiert, die mit der Signumfunktion des Eingangssignals getriggert wird.

Die Effizienz eines Verstärkers ist definiert als das Verhältnis von Durchschnittsleistung des Ausgangssignals zur Eingangsleistung, wobei die Eingangsleistung wiederum die Durchschnittsleistung ist, die von der Hilfs-Leistungsquelle bereitgestellt und zur Leistung des Eingangssignals addiert wird. Die Effizienz eines schwach nicht-linearen Verstärkers ist vergleichsweise gering und verringert sich weiter für Signale mit einem großen Spitze-Mittelwert-Verhältnis.

Im Gegensatz dazu zeigen Schaltverstärker eine Effizienz beziehungsweise einen Wirkungsgrad von nahezu 1, was darin begründet ist, dass idealerweise die Spannung über, beziehungsweise der Strom durch das Schaltelement zu jeder Zeit Null ist. Von der Energieeffizienz-Seite her betrachtet ist ein Schaltverstärker daher bevorzugt.

Nachteilig ist jedoch, dass ein Schaltverstärker jegliche Amplitudeninformation aus dem Eingangssignal per Definition entfernt. Deshalb muss die Amplitude des Eingangssignals durch zusätzliche Anwendung eines Impulsmodulationsschemas am Eingang des Verstärkers beibehalten werden, was in einem binären Eingangssignal resultiert, wobei sämtliche Informationen in den Nulldurchgängen des Signals eingesteckt werden. Ausgangsseitig wird eine zusätzliche Demodulation des verstärkten Binärsignals benötigt, um das Originalsignal zu rekonstruieren. Darüber hinaus erzeugt die Modulation ungewollte Spektralkomponenten außerhalb des Frequenzbands, die von der Demodulation unterdrückt werden müssen. Andererseits würde sich das gesamte System - Modulator, Schaltverstärker, Demodulator - definitionsgemäß nicht wie ein linearer Leistungsverstärker verhalten.

Um eine unverzerrte, d.h. eine lineare Verstärkung der Signalkurve zu erhalten, muss die Verstärkervorrichtung mit einer gewissen Aussteuerrungsreserve, d.h. mit einem Power Back-Off betrieben werden, was jedoch wiederum die Leistungs-Effizienz des Verstärkers reduziert. Anderenfalls verzerrt der Verstärker das Bandpass-Signal nicht-linear und produziert so ungewollte Verzerrungen innerhalb, sowie Emissionen außerhalb des Frequenzbands.

Die ungenügende Leistungs-Effizienz von Verstärkern für Bandpass-Signale, welche bei modernen Drahtlos-Kommunikationssignalen lediglich 10 Prozent oder weniger betragen kann, führt zu einem erhöhten Bedarf an neuen Verstärker-Konzepten. Aktuelle Ansätze, die adaptive Digitalfilter-Vorverzerrungen nutzen, zeigen einen überaus erhöhten Bedarf an Hardware-Einsatz. Deshalb besteht außerdem der Bedarf an integrierten Lösungen mit reduzierter Hardware-Komplexität.

Es sind mehrere Lösungen bekannt, um die Leistungs-Effizienz für Bandpass-Verstärker zu erhöhen. Auf Schaltkreisebene stellt die Doherty Topologie eine höhere Effizienz für Hochleistungs-Back-Off-Werte bereit. Hüllkurveneliminierung und -wiederherstellung sowie Vorspannungsmodulation sind weitere Techniken auf Systemebene, um die Effizienz in der Back-Off Region zu erhöhen. Analoge feed-forward und feed-back Schaltkreise können genutzt werden, um die Linearität niedriger Back-Offs zu verbessern, was ebenfalls die Leistungs-Effizienz erhöht. Im Gegensatz dazu ist die closed-loop Digital-Vorverzerrung auf Systemebene implementiert und zeigt bessere Linearitäts-Verbesserungen für Signale mit vergleichbar großer Bandbreite. Sie ist außerdem geeignet, um zeitliche Änderungen in der Verstärkervorrichtung anzupassen.

Während die erwähnten Lösungen zur Verbesserung von Verstärkern mit im Wesentlichen linearem Verhalten konzipiert sind, sind die Schaltverstärker-Techniken dazu gedacht, um Bandpass-Signale in eine Abfolge rechteckiger, binärer Impulse zu überführen, die mit einer theoretischen Effizienz von 100 Prozent verstärkt werden können. Nach der Verstärkung wird das originale Bandpass-Signal durch Tiefpass-Filterung rekonstruiert. Von technischer Seite her betrachtet, kann die Transformation und Rekonstruktion als ein Pulsmodulations- und -demodulationsproblem angesehen werden. Eine bekannte Schaltverstärker-Technik nutzt die Pulsweitenmodulation (PWM), welche ein feed-forward Modulationsschema ist. Eine weitere bekannte Schaltverstärker-Technik nutzt die Sigma-Delta-Modulation (SDM), welche ein closed-loop Modulationsschema ist.

Bei beiden besteht jedoch der Nachteil, dass sie Signalverzerrungen innerhalb des Frequenzbands erzeugen, die von dem Demodulator nicht entfernt werden können. Diese Signalverzerrungen können durch eine Erhöhung der Schaltfrequenz, durch Überabtastung oder durch eine loopback-Filterung höherer Ordnung (für SDM) verringert werden. Dies erhöht die Anforderung an die Verstärkervorrichtung und somit die Kosten von Schaltverstärkern, vor allem für den Betrieb bei hohen Signalfrequenzen, welche typisch bei Funkfrequenzen und Mikrowellen-Anwendungen sind. Darüber hinaus tendiert die closed-loop Architektur der Sigma-Delta Modulation zu Instabilitäts-Problemen bei sehr hohen Betriebsfrequenzen aufgrund ihrer feedback-Verzögerung.

Eine gattungsgemäße Verstärkervorrichtung ist beispielsweise aus der EP 2 498 397 A1 bekannt. Hier wird zur Erhöhung einer Trägerfrequenz $f_c$ eine zusätzliche Hilfsfrequenz $f_a$ hinzugemischt, was zu einer resultierenden Mischfrequenz $f_m$ führt. Hierbei ergibt sich ein Zweiseitenbandmodulator, der eine Zerlegung auf zwei Frequenzbänder der gleichen Breite BW, die sich um $f_a \pm f_m$ konzentrieren, liefert. Der Implementierungsaufwand, der sich unter anderem durch die Bereitstellung eines weiteren Oszillators zur Erzeugung der zusätzlichen Hilfsfrequenz $f_a$ ergibt, ist jedoch relativ hoch.

Es ist demnach eine Aufgabe der vorliegenden Erfindung, ein Konzept zum Verstärken eines Eingangssignals vorzuschlagen, das einen verbesserten Kompromiss zwischen Implementierungs-Aufwand und Leistungseffizienz sowie Linearität bereitstellt.

Diese Aufgabe wird erfindungsgemäß mit einer Vorrichtung zum Verstärken eines Eingangssignals gemäß Anspruch 1 sowie mit einem Verfahren zum Verstärken eines Eingangssignals gemäß Anspruch 16 gelöst. Alternativ wird die Aufgabe erfindungsgemäß mit einer Vorrichtung zum Verstärken eines Eingangssignals gemäß Anspruch 6 sowie mit einem Verfahren zum Verstärken eines Eingangssignals gemäß Anspruch 19 gelöst. Ferner alternativ wird die Aufgabe erfindungsgemäß mit einer Vorrichtung zum Verstärken eines Eingangssignals gemäß Anspruch 10 sowie mit einem Verfahren zum Verstärken eines Eingangssignals gemäß Anspruch 20 gelöst.

Gemäß einer Ausführungsform der Erfindung wird eine Vorrichtung zum Verstärken eines Eingangssignals vorgeschlagen, die unter anderem einen Leistungsverstärker zum Eine gattungsgemäße Verstärkervorrichtung ist beispielsweise aus der EP 2 498 397 A1 bekannt. Hier wird zur Erhöhung einer Trägerfrequenz $f_c$ eine zusätzliche Hilfsfrequenz $f_a$ hinzugemischt, was zu einer resultierenden Mischfrequenz $f_m$ führt. Hierbei ergibt sich ein Zweiseitenbandmodulator, der eine Zerlegung auf zwei Frequenzbänder der gleichen Breite BW, die sich um $f_a \pm f_m$ konzentrieren, liefert. Der Implementierungsaufwand, der sich unter anderem durch die Bereitstellung eines weiteren Oszillators zur Erzeugung der zusätzlichen Hilfsfrequenz $f_a$ ergibt, ist jedoch relativ hoch.

Es ist demnach eine Aufgabe der vorliegenden Erfindung, ein Konzept zum Verstärken eines Eingangssignals vorzuschlagen, das einen verbesserten Kompromiss zwischen Implementierungs-Aufwand und Leistungseffizienz sowie Linearität bereitstellt.

Diese Aufgabe wird erfindungsgemäß mit einer Vorrichtung zum Verstärken eines Eingangssignals gemäß Anspruch 1 gelöst.

Gemäß einer Ausführungsform der Erfindung wird eine Vorrichtung zum Verstärken eines Eingangssignals vorgeschlagen, die unter anderem einen Leistungsverstärker zum Verstärken eines binären Eingangssignals aufweist. Die erfindungsgemäße Vorrichtung weist ferner eine Modulationsvorrichtung zum Erzeugen des binären Eingangssignals basierend auf dem Eingangssignal auf, wobei das Eingangssignal ein komplexwertiges Signal ist und das binäre Eingangssignal ein reellwertiges Signal ist. Die Modulationsvorrichtung weist eine Addiervorrichtung auf, die ausgebildet ist, um das komplexwertige Eingangssignal mit einem komplexwertigen Trägersignal einer vorgegebenen Frequenz zu addieren und so ein resultierendes komplexwertiges Signal zu generieren. Die Modulationsvorrichtung weist ferner eine der Addiervorrichtung nachgeschaltete Kombinationsvorrichtung auf, die ausgebildet ist, um aus dem Realteil und dem Imaginärteil des resultierenden komplexwertigen Signals das reellwertige binäre Verstärken eines binären Eingangssignals aufweist. Die erfindungsgemäße Vorrichtung weist ferner eine Modulationsvorrichtung zum Erzeugen des binären Eingangssignals basierend auf dem Eingangssignal auf, wobei das Eingangssignal ein komplexwertiges Signal ist und das binäre Eingangssignal ein reellwertiges Signal ist. Die Modulationsvorrichtung weist eine Addiervorrichtung auf, die ausgebildet ist, um das komplexwertige Eingangssignal mit einem komplexwertigen Trägersignal einer vorgegebenen Frequenz zu addieren und so ein resultierendes komplexwertiges Signal zu generieren. Die Modulationsvorrichtung weist ferner eine der Addiervorrichtung nachgeschaltete Kombinationsvorrichtung auf, die ausgebildet ist, um aus dem Realteil und dem Imaginärteil des resultierenden komplexwertigen Signals das reellwertige binäre Eingangssignal durch eine Kombination des Realteils und des Imaginärteils des resultierenden komplexwertigen Signals zu erzeugen.

In der Ausgestaltung gemäß den Ansprüchen 1 und 16 weist die Kombinationsvorrichtung einen Multiplizierer zum Multiplizieren des Realteils und des Imaginärteils des resultierenden komplexwertigen Signals sowie einen nachgeschalteten Komparator auf. Ferner weist die Vorrichtung ein Tiefpassfilter auf, das dem Leistungsverstärker seriell nachgeschaltet ist, wobei das Eingangssignal des Tiefpassfilters das von dem Leistungsverstärker erzeugte verstärkte Ausgangssignal ist.

In der alternativen Ausgestaltung gemäß den Ansprüchen 6 und 19 weist die Kombinationsvorrichtung einen ersten Komparator zum Verarbeiten des Realteils und einen zweiten Komparator zum Verarbeiten des Imaginärteils des resultierenden komplexwertigen Signals sowie ein den ersten und zweiten Komparatoren seriell nachgeschaltetes XOR-Gatter zum Zusammenführen der Ausgangssignale der ersten und zweiten Komparatoren auf. Auch hier weist die Vorrichtung zusätzlich ein Tiefpassfilter auf, das dem Leistungsverstärker seriell nachgeschaltet ist, wobei das Eingangssignal des Tiefpassfilters das von dem Leistungsverstärker erzeugte verstärkte Ausgangssignal ist.

In der alternativen Ausgestaltung gemäß den Ansprüchen 10 und 20 weist die Kombinationsvorrichtung einen ersten und einen zweiten Multiplizierer auf, wobei der erste Multiplizierer dem ersten Addierer seriell nachgeschaltet ist, und der zweite Multiplizierer dem zweiten Addierer seriell nachgeschaltet ist, und wobei der erste Multiplizierer ausgebildet ist, um ein aus dem Realteil gebildetes zeitdiskretes Ausgangssignal des ersten Addierers zeitlich mit sich selbst zu multiplizieren, und wobei der zweite Multiplizierer ausgebildet ist, um ein aus dem Imaginärteil gebildetes zeitdiskretes Ausgangssignal des zweiten Addierers zeitlich mit sich selbst zu multiplizieren. Auch hier weist die Vorrichtung zusätzlich ein Tiefpassfilter auf, das dem Leistungsverstärker seriell nachgeschaltet ist, wobei das Eingangssignal des Tiefpassfilters das von dem Leistungsverstärker erzeugte verstärkte Ausgangssignal ist.

In einigen erfindungsgemäßen Ausführungsformen ist die Modulationsvorrichtung unter anderem dazu ausgebildet, um ein digitales Eingangssignal für den Leistungsverstärker zu erzeugen, basierend auf dem Eingangssignal, welches zum Beispiel ein reellwertiges Basisbandsignal, ein komplexwertiges Basisbandsignal, ein reellwertiges Bandpasssignal, oder ein komplexwertiges Bandpasssignal sein kann. Das erzeugte digitale Eingangssignal befindet sich in einem vordefinierten Frequenzband. Verzerrungen, die beispielsweise bei der Erzeugung des digitalen Eingangssignals für den Leistungsverstärker entstehen, befinden sich hingegen bei einer Frequenz außerhalb des vordefinierten Frequenzbands. Somit weist das digitale Eingangssignal keine Verzerrungen innerhalb des vordefinierten Frequenzbands, beziehungsweise innerhalb des Frequenzspektrums des gewünschten und von dem Leistungsverstärker zu verstärkenden digitalen Eingangssignals auf. Darüber hinaus stellt der Leistungsverstärker eine Verstärkung des digitalen Eingangssignals mit einer erhöhten Leistungseffizienz bereit. Da sich die Verzerrungen außerdem nicht innerhalb des vordefinierten Frequenzbands des digitalen Eingangssignals befinden, kann eine hohe Linearität bei der Verstärkung erreicht werden, zum Beispiel durch Rekonstruktionsfilterung des verstärkten digitalen Eingangssignals (Ausgangssignal des Leistungsverstärkers). Somit werden Verzerrungen außerhalb des Frequenzbands, sprich von Frequenzen, die oberhalb des vordefinierten Frequenzbands liegen, reduziert beziehungsweise eliminiert, ohne dabei den gewünschten Signalanteil zu verändern.

Ausführungsbeispiele der Erfindung sind in der Zeichnung dargestellt und werden nachstehend erläutert. Es zeigen:

Fig. 1     ein schematisches Blockschaltbild einer erfindungsgemäßen Vorrichtung,

Fig. 2     ein schematisches Blockschaltbild einer ersten Ausführungsform der erfindungsgemäßen Vorrichtung,

Fig. 3     ein schematisches Blockschaltbild einer zweiten Ausführungsform der erfindungsgemäßen Vorrichtung

Fig. 4     ein schematisches Blockschaltbild einer dritten Ausführungsform der erfindungsgemäßen Vorrichtung,

Fig. 5    ein schematisches Blockschaltbild einer vierten Ausführungsform der erfindungsgemäßen Vorrichtung, und

Fig. 6    ein schematisches Blockschaltbild einer fünften Ausführungsform der erfindungsgemäßen Vorrichtung.

Zum Zwecke der folgenden Beschreibung der erfindungsgemäßen Ausführungsformen mit Bezug auf die Figuren werden komplexwertige Signale in den Figuren mit einem Doppelpfeil dargestellt. Die einzelnen Anteile, das heißt die Realteile und die Imaginärteile dieser komplexwertigen Signale werden mit einfachen Pfeilen dargestellt.

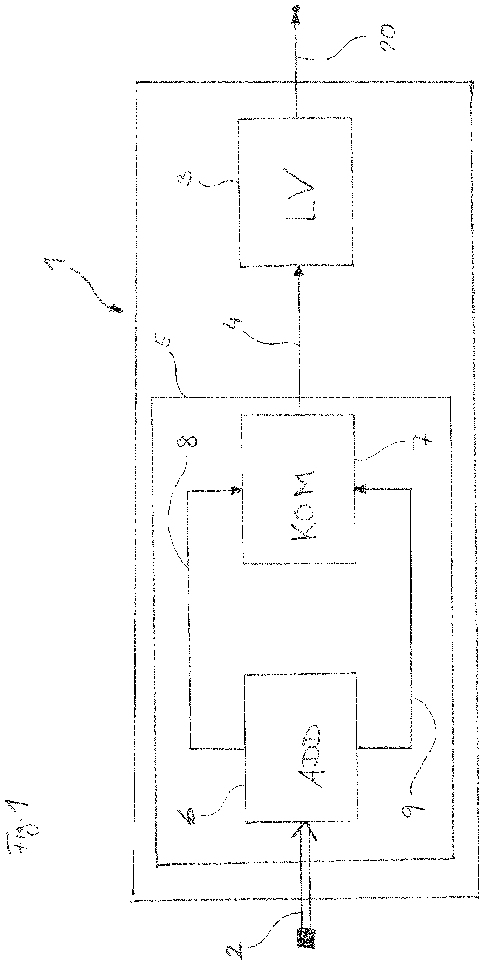

Figur 1 zeigt eine erfindungsgemäße Vorrichtung 1 zum Verstärken eines Eingangssignals 2. Das Eingangssignal 2 ist komplexwertig, das heißt das Eingangssignal 2 weist einen Realteil und einen Imaginärteil auf.

Die Vorrichtung 1 weist einen Schalt- beziehungsweise Leistungsverstärker 3 auf. Der Leistungsverstärker 3 ist ausgebildet, um ein reellwertiges binäres Eingangssignal 4 zu verstärken.

Die Vorrichtung 1 weist außerdem eine Modulationsvorrichtung 5 auf. Die Modulationsvorrichtung 5 ist ausgebildet, um das reellwertige binäre Eingangssignal 4 des Leistungsverstärkers 3 basierend auf dem komplexwertigen Eingangssignal 2 zu erzeugen.

Hierfür weist die Modulationsvorrichtung 5 unter anderem eine Addiervorrichtung 6 auf. Die Addiervorrichtung 6 ist ausgebildet, um das komplexwertige Eingangssignal 2 mit einem komplexwertigen Trägersignal einer vorgegebenen Frequenz zu addieren und so ein resultierendes komplexwertiges Signal zu generieren. Dieses modulierte Signal weist einen Realteil 8 und einen Imaginärteil 9 auf.

Die Modulationsvorrichtung 5 weist ferner eine der Addiervorrichtung 6 nachgeschaltete Kombinationsvorrichtung 7 auf. Die Kombinationsvorrichtung 7 ist ausgebildet, um aus dem Realteil 8 und dem Imaginärteil 9 des resultierenden modulierten komplexwertigen Signals das reellwertige binäre Eingangssignal 4 zu erzeugen. Hierfür ist die Kombinationsvorrichtung 7 ausgebildet, um das Eingangssignal 4 durch eine geeignete Kombination des Realteils 8 und des Imaginärteils 9 des modulierten Signals zu erzeugen.

Das so erzeugte Eingangssignal 4 des Leistungsverstärkers 3 ist also gleichzeitig das Ausgangssignal der Modulationsvorrichtung 5, beziehungsweise der Kombinationsvorrichtung 7.

Der Leistungsverstärker 3 verstärkt das Eingangssignal 4, so dass ein Ausgangssignal 20 des Leistungsverstärkers 3 erzeugt wird, welches ein verstärktes Signal beziehungsweise eine verstärkte Version des binären Eingangssignals 4 ist.

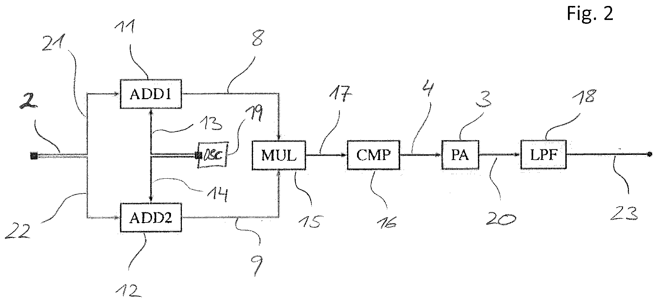

Figur 2 zeigt eine erste Ausführungsform der erfindungsgemäßen Verstärkervorrichtung 1 gemäß einer ersten Variante. Das Eingangssignal 2 ist komplexwertig und weist einen Realteil 21 und einen Imaginärteil 22 auf. Das Eingangssignal 2 kann zeitkontinuierlich oder zeitdiskret sein. In der mit Bezug auf Figur 2 beschriebenen ersten Ausführungsform ist das Eingangssignal 2 ein komplexwertiges zeitkontinuierliches Signal.

Die Verstärkervorrichtung 1 weist einen Oszillator 19 zum Erzeugen eines Trägersignals 13, 14 mit einer Trägerfrequenz $f_c$ auf. Das Trägersignal 13, 14 ist komplexwertig und weist einen Realteil 13 und einen Imaginärteil 14 auf.

Der Oszillator 19 kann ein analoger oder ein digitaler Oszillator zum Erzeugen eines analogen beziehungsweise digitalen Signals sein. Die in Figur 2 dargestellte erste Ausführungsform der Erfindung wird exemplarisch mit einem analogen Oszillator 19 beschrieben.

Die Addiervorrichtung 6 weist einen ersten Addierer 11 und einen zweiten Addierer 12 auf. Der erste Addierer 11 ist ausgebildet, um den Realteil 21 des Eingangssignals 2 mit dem Realteil 13 des Trägersignals zu addieren. Am Ausgang des ersten Addierers 11 wird somit der Realteil 8 eines resultierenden modulierten Signals erhalten.

Der zweite Addierer 12 ist ausgebildet, um den Imaginärteil 22 des Eingangssignals 2 mit dem Imaginärteil 14 des Trägersignals zu addieren. Am Ausgang des zweiten Addierers 12 wird somit der Imaginärteil 9 eines resultierenden modulierten Signals erhalten.

Die Verstärkervorrichtung 1 weist ferner einen Multiplizierer 15 sowie einen Komparator 16 auf. Der Multiplizierer 15 ist gemäß der ersten Ausführungsform der Erfindung den zuvor beschriebenen Addierern 11, 12 nachgeschaltet. Der Komparator 16 ist dem Multiplizierer 15 nachgeschaltet.

Sowohl der Realteil 8 des modulierten Ausgangssignals des ersten Addierers 11 als auch der Imaginärteil 9 des modulierten Ausgangssignals des zweiten Addierers 12 werden in den Multiplizierer 15 geführt und dort zu einem reellwertigen analogen Ausgangssignal 17 kombiniert.

Dieses reellwertige analoge Ausgangssignal 17 des Multiplizierers 15 ist gleichzeitig das Eingangssignal des Komparators 16. Der Komparator 16 ist ausgebildet, um aus dem reellwertigen analogen Ausgangssignal 17 ein reellwertiges binäres Signal 4 zu erzeugen. Das Ausgangssignal 4 des Komparators 16 ist das binäre Eingangssignal 4 des Leistungsverstärkers 3. Das Binärsignal 4 ist binär betreffend die Amplitude und zeitkontinuierlich. Das Binärsignal 4 dient zur Ansteuerung der Leistungskomponenten des Leistungsverstärkers 3.

Der Leistungsverstärker 3 erzeugt ein verstärktes Ausgangssignal 20, das eine verstärkte Version des binären Eingangssignals 4 ist.

Die Verstärkervorrichtung 1 weist ferner ein Rekonstruktionsfilter 18 auf. In der in Figur 2 dargestellten ersten Ausführungsform der ersten Variante handelt es sich um ein dem Leistungsverstärker 3 nachgeschaltetes Tiefpassfilter 18. Das Binärsignal 20 wird in dem Rekonstruktionsfilter 18 zu einem Ausgangssignal 23 rekonstruiert. Sei das Eingangssignal 2 gleich Z(t) und die Trägerfrequenz gleich $f_c$, so weist das Ausgangssignal 23 die folgende Signalform ohne einen weiteren Verstärkungsfaktor auf:

$$\mathrm{Re}\{Z(t)\} * \mathrm{Im}\{e^{j2\pi fct}\} + \mathrm{Im}\{Z(t)\}* \mathrm{Re}\{e^{j2\pi fct}\} = \mathrm{Im}\{Z(t)*e^{j2\pi fct}\}$$

Gemäß der abgebildeten Ausführungsform ist also das Rekonstruktionsfilter 18 dem Leistungsverstärker 3 seriell nachgeschaltet und das Eingangssignal 20 des Rekonstruktionsfilters 18 ist das von dem Leistungsverstärker 3 erzeugte verstärkte Ausgangssignal 20. Erfindungsgemäß wird so der Außenband-Signalanteil des verstärkten Binärsignals 20 ausgefiltert.

Generell besteht das verstärkte Binärsignal 20 aus einem Inband-Signalanteil und einem Außenband-Signalanteil. Der Außenband-Signalanteil wird durch das Rekonstruktionsfilter 18 ausgefiltert. Der Inband-Signalanteil ist ausschließlich das reellwertige Ausgangssignal 23 des ganzen Systems 1. In anderen Worten ist der Inband-Signalanteil des verstärkten Binärsignals 20 eine verstärkte, mit der Trägerfrequenz fc hochmodulierte Version des Basisband-Eingangssignals 2 der gesamten erfindungsgemäßen Vorrichtung 1.

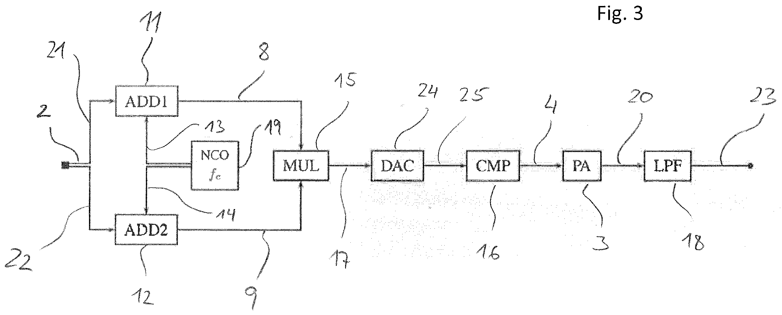

Figur 3 zeigt eine zweite Ausführungsform der erfindungsgemäßen Verstärkervorrichtung 1 gemäß der ersten Variante. Das Eingangssignal 2 ist komplexwertig und weist einen Realteil 21 und einen Imaginärteil 22 auf. Das Eingangssignal 2 kann zeitkontinuierlich, beziehungsweise analog, oder zeitdiskret, beziehungsweise digital, sein. In der mit Bezug auf Figur 3 beschriebenen zweiten Ausführungsform ist das Eingangssignal 2 ein komplexwertiges zeitdiskretes Signal.

Die Verstärkervorrichtung 1 weist einen digitalen numerisch kontrollierten Oszillator 19 zum Erzeugen eines digitalen Trägersignals 13, 14 mit einer Trägerfrequenz $f_c$ auf. Das Trägersignal 13, 14 ist komplexwertig und weist einen Realteil 13 und einen Imaginärteil 14 auf.

Die Addiervorrichtung 6 weist einen ersten Addierer 11 und einen zweiten Addierer 12 auf. Der erste Addierer 11 ist ausgebildet, um den Realteil 21 des Eingangssignals 2 mit dem Realteil 13 des Trägersignals zu addieren. Am Ausgang des ersten Addierers 11 wird somit der Realteil 8 eines resultierenden modulierten Signals erhalten.

Der zweite Addierer 12 ist ausgebildet, um den Imaginärteil 22 des Eingangssignals 2 mit dem Imaginärteil 14 des Trägersignals zu addieren. Am Ausgang des zweiten Addierers 12 wird somit der Imaginärteil 9 eines resultierenden modulierten Signals erhalten.

Die Kombinationsvorrichtung 7 weist gemäß diesem Ausführungsbeispiel eine Reihenschaltung bestehend aus einem Multiplizierer 15, einem dem Multiplizierer 15 nachgeschalteten Digital-Analog-Wandler 24 und einem dem Digital-Analog-Wandler 24 nachgeschalteten Komparator 16 auf.

Der Multiplizierer 15 ist den zuvor beschriebenen Addierern 11, 12 nachgeschaltet. Sowohl der Realteil 8 des modulierten Ausgangssignals des ersten Addierers 11 als auch der Imaginärteil 9 des modulierten Ausgangssignals des zweiten Addierers 12 werden in den Multiplizierer 15 geführt und dort zu einem reellwertigen digitalen Ausgangssignal 17 kombiniert.

Dem Multiplizierer 15 ist ein Digital-Analog-Wandler 24 nachgeschaltet. Das reellwertige digitale Ausgangssignal 17 des Multiplizierers 15 ist gleichzeitig das digitale Eingangssignal des Digital-Analog-Wandlers 24, der daraus ein analoges Signal 25 erzeugt.

Die Verstärkervorrichtung 1 weist ferner einen Komparator 16 auf, der dem Digital-Analog-Wandler 24 nachgeschaltet ist. Das analoge Ausgangssignal 25 des Digital-Analog-Wandlers 24 ist gleichzeitig das Eingangssignal des nachgeschalteten Komparators 16, der daraus das binäre zeitkontinuierliche Eingangssignal 4 des Leistungsverstärkers 3 erzeugt. Das Binärsignal 4 ist binär betreffend die Amplitude und zeitkontinuierlich. Das Binärsignal 4 dient zur Ansteuerung der Leistungskomponenten des Leistungsverstärkers 3.

Der Leistungsverstärker 3 erzeugt ein verstärktes Ausgangssignal 20, das eine verstärkte Version des binären Eingangssignals 4 ist.

Die Verstärkervorrichtung 1 weist ferner ein Rekonstruktionsfilter 18 auf. In der in Figur 3 dargestellten zweiten Ausführungsform der ersten Variante handelt es sich um ein dem Leistungsverstärker 3 nachgeschaltetes Tiefpassfilter 18. Das Binärsignal 20 wird in dem Rekonstruktionsfilter 18 zu einem Ausgangssignal 23 rekonstruiert. Sei das Eingangssignal 2 gleich Z(t) und die Trägerfrequenz gleich $f_c$, so weist das Ausgangssignal 23 die folgende Signalform ohne einen weiteren Verstärkungsfaktor auf:

$$\mathrm{Re}\{Z(t)\} * \mathrm{Im}\{e^{j2\pi fct}\} + \mathrm{Im}\{Z(t)\}* \mathrm{Re}\{e^{j2\pi fct}\} = \mathrm{Im}\{Z(t)*e^{j2\pi fct}\}$$

Gemäß der abgebildeten Ausführungsform ist also das Rekonstruktionsfilter 18 dem Leistungsverstärker 3 seriell nachgeschaltet und das Eingangssignal 20 des Rekonstruktionsfilters 18 ist das von dem Leistungsverstärker 3 erzeugte verstärkte Ausgangssignal 20. Erfindungsgemäß wird so der Außenband-Signalanteil des verstärkten Binärsignals 20 ausgefiltert.

Generell besteht das verstärkte Binärsignal 20 aus einem Inband-Signalanteil und einem Außenband-Signalanteil. Der Außenband-Signalanteil wird durch das Rekonstruktionsfilter 18 ausgefiltert. Der Inband-Signalanteil ist ausschließlich das reellwertige Ausgangssignal 23 des ganzen Systems 1. In anderen Worten ist der Inband-Signalanteil des verstärkten Binärsignals 20 eine verstärkte, mit der Trägerfrequenz fc hochmodulierte Version des Basisband-Eingangssignals 2 der gesamten erfindungsgemäßen Vorrichtung 1.

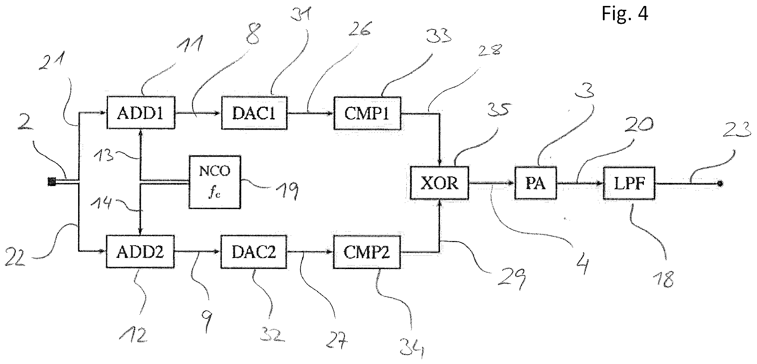

Wie in den Figuren 1 bis 3 gezeigt, wird der Realteil 21 und der Imaginärteil 22 des Eingangssignals 2 unabhängig voneinander in den Ausgangssignalen 8, 9 der Addiervorrichtung 6 kodiert und danach am Ausgang wieder linear überlagert. Ihre Informationen werden separat in den jeweiligen Nulldurchgängen des Realteils 8 beziehungsweise des Imaginärteils 9 eingesteckt. Weil diese Nulldurchgänge miteinander verschachtelt sind, können der Multiplizierer 15 und der Komparator 16 der Kombiniervorrichtung 7 durch zwei Komparatoren zusammen mit einem XOR-Gatter ersetzt werden. Die Nulldurchgänge beider Signale werden zunächst mit Hilfe der Komparatoren entdeckt und dann anhand des XOR-Gatters im binären Eingangssignal 4 des Leistungsverstärkers 3 zusammengefasst. Eine solche Ausführungsform ist mit Bezug auf Figur 4 dargestellt.

Figur 4 zeigt eine Ausführungsform der erfindungsgemäßen Vorrichtung 1 gemäß einer alternativen zweiten Variante.

Die Vorrichtung 1 weist einen Oszillator 19 zum Erzeugen eines digitalen Mischsignals beziehungsweise Trägersignals der Trägerfrequenz fc auf. Das Mischsignal weist einen Realteil 13 und einen Imaginärteil 14 auf.

Die Addiervorrichtung 6 weist einen ersten Addierer 11 und einen zweiten Addierer 12 auf.

Die Kombinationsvorrichtung 7 weist einen ersten Digital-Analog-Wandler 31, einen zweiten Digital-Analog-Wandler 32, einen ersten Komparator 33, einen zweiten Komparator 34 und ein logisches XOR-Gatter 35 auf.

Der erste Digital-Analog-Wandler 31 sowie der erste Komparator 33 sind zur Verarbeitung des Realteils 21 des Eingangssignals 2 vorgesehen. Der zweite Digital-Analog-Wandler 32 sowie der zweite Komparator 34 sind zur Verarbeitung des Imaginärteils 22 des Eingangssignals 2 vorgesehen.

Der erste Digital-Analog-Wandler 31 ist dem ersten Addierer 11 seriell nachgeschaltet. Der erste Komparator 33 ist dem ersten Digital-Analog-Wandler 31 seriell nachgeschaltet.

Der zweite Digital-Analog-Wandler 32 ist dem zweiten Addierer 12 seriell nachgeschaltet. Der zweite Komparator 34 ist dem zweiten Digital-Analog-Wandler 34 seriell nachgeschaltet.

Die Ausgänge des ersten Komparators 33 beziehungsweise des zweiten Komparators 34 werden in dem seriell nachgeschalteten logischen XOR-Gatter 35 zusammengeführt und logisch miteinander verknüpft.

Das Eingangssignal 2 ist komplexwertig und weist einen Realteil 21 und einen Imaginärteil 22 auf. Das Eingangssignal 2 kann zeitkontinuierlich oder zeitdiskret sein. In der mit Bezug auf Figur 4 beschriebenen Ausführungsform der zweiten Variante ist das Eingangssignal 2 ein komplexwertiges zeitdiskretes Signal.

Der erste Addierer 11 ist ausgebildet, um den Realteil 21 des Eingangssignals 2 mit dem Realteil 13 des Trägersignals zu addieren. Am Ausgang des ersten Addierers 11 wird somit der Realteil 8 eines resultierenden modulierten Signals erhalten.

Der zweite Addierer 12 ist ausgebildet, um den Imaginärteil 22 des Eingangssignals 2 mit dem Imaginärteil 14 des Trägersignals zu addieren. Am Ausgang des zweiten Addierers 12 wird somit der Imaginärteil 9 eines resultierenden modulierten Signals erhalten.

Das Ausgangssignal des ersten Addierers 11, das heißt das digitale modulierte Signal 8, wird in den ersten Digital-Analog-Wandler 31 geführt und dort in ein analoges Signal 26 gewandelt. Das analoge Signal 26 ist das Eingangssignal des ersten Komparators 33. Der erste Komparator 33 ist ausgebildet, um das analoge Eingangssignal 26 in ein analoges Binärsignal 28 zu wandeln.

Das Ausgangssignal des zweiten Addierers 12, das heißt das digitale modulierte Signal 9, wird in den zweiten Digital-Analog-Wandler 32 geführt und dort in ein analoges Signal 27 gewandelt. Das analoge Signal 27 ist das Eingangssignal des zweiten Komparators 34. Der zweite Komparator 34 ist ausgebildet, um das analoge Eingangssignal 27 in ein analoges Binärsignal 29 zu wandeln.

Die Ausgangssignale 28, 29 des ersten Komparators 33 beziehungsweise des zweiten Komparators 34 werden in dem nachgeschalteten logischen XOR-Gatter 35 zusammengeführt. Das XOR-Gatter 35 erzeugt das binäre Eingangssignal 4 des Leistungsverstärkers 3. Das Binärsignal 4 ist binär betreffend die Amplitude und zeitkontinuierlich. Das Binärsignal 4 dient zur Ansteuerung der Leistungskomponenten des Leistungsverstärkers 3.

Der Leistungsverstärker 3 erzeugt ein verstärktes Ausgangssignal 20, das eine verstärkte Version des binären Eingangssignals 4 ist.

Die Verstärkervorrichtung 1 weist ferner ein Rekonstruktionsfilter 18 auf. In der in Figur 4 dargestellten Ausführungsform der zweiten Variante handelt es sich um ein dem Leistungsverstärker 3 nachgeschaltetes Tiefpassfilter 18. Das Binärsignal 20 wird in dem Rekonstruktionsfilter 18 zu einem Ausgangssignal 23 rekonstruiert. Sei das Eingangssignal 2 gleich Z(t) und die Trägerfrequenz gleich $f_c$, so weist das Ausgangssignal 23 die folgende Signalform ohne einen weiteren Verstärkungsfaktor auf:

$$Re\{Z(t)\} * Im\{e^{j2\pi fct}\} + Im\{Z(t)\}* Re\{e^{j2\pi fct}\} = Im\{Z(t)*e^{j2\pi fct}\}$$

Gemäß der abgebildeten Ausführungsform ist also das Rekonstruktionsfilter 18 dem Leistungsverstärker 3 seriell nachgeschaltet und das Eingangssignal 20 des Rekonstruktionsfilters 18 ist das von dem Leistungsverstärker 3 erzeugte verstärkte Ausgangssignal 20. Erfindungsgemäß wird so der Außenband-Signalanteil des verstärkten Binärsignals 20 ausgefiltert.

Generell besteht das verstärkte Binärsignal 20 aus einem Inband-Signalanteil und einem Außenband-Signalanteil. Der Außenband-Signalanteil wird durch das Rekonstruktionsfilter 18 ausgefiltert. Der Inband-Signalanteil ist ausschließlich das reellwertige Ausgangssignal 23 des ganzen Systems 1. In anderen Worten ist der Inband-Signalanteil des verstärkten Binärsignals 20 eine verstärkte, mit der Trägerfrequenz fc hochmodulierte Version des Basisband-Eingangssignals 2 der gesamten erfindungsgemäßen Vorrichtung 1.

Bei der Vorrichtung in Figur 4 kann das Eingangssignal 2 analog sein. In diesem Fall wäre der Oszillator 19 ein analoger Oszillator zum Erzeugen eines analogen Trägersignals der Trägerfrequenz $f_c$ und der erste sowie der zweite Digital-Analog-Wandler 31, 32 könnten entfallen.

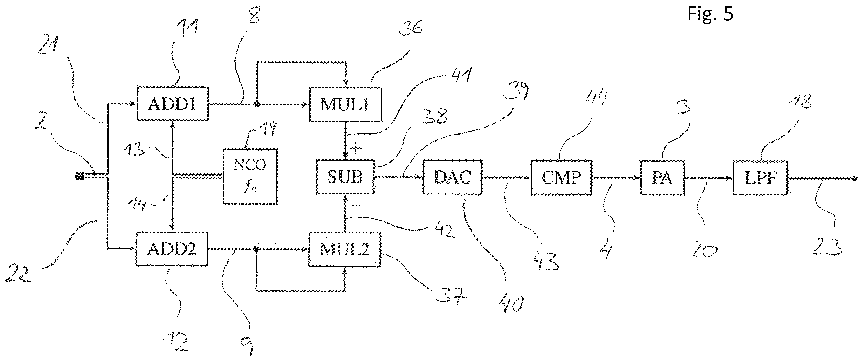

Figur 5 zeigt eine erste Ausführungsform der erfindungsgemäßen Vorrichtung 1 gemäß einer dritten Variante.

Das Eingangssignal 2 ist komplexwertig und weist einen Realteil 21 und einen Imaginärteil 22 auf. Das Eingangssignal 2 kann zeitkontinuierlich oder zeitdiskret sein. In der mit Bezug auf Figur 5 beschriebenen ersten Ausführungsform der dritten Variante ist das Eingangssignal 2 ein komplexwertiges zeitdiskretes Signal.

Die Vorrichtung 1 weist einen numerischen Oszillator 19 zum Erzeugen eines digitalen Mischsignals beziehungsweise Trägersignals der Trägerfrequenz fc auf. Das Mischsignal weist einen Realteil 13 und einen Imaginärteil 14 auf.

Die Addiervorrichtung 6 weist einen ersten Addierer 11 und einen zweiten Addierer 12 auf.

Die Kombinationsvorrichtung 7 weist einen ersten Multiplizierer 36, einen zweiten Multiplizierer 37 und einen Subtrahierer 38 auf.

Der erste Multiplizierer 36 ist zur Verarbeitung des Realteils 21 des Eingangssignals 2 vorgesehen. Der zweite Multiplizierer 37 ist zur Verarbeitung des Imaginärteils 22 des Eingangssignals 2 vorgesehen.

Der erste Multiplizierer 36 ist dem ersten Addierer 11 seriell nachgeschaltet. Der zweite Multiplizierer 37 ist dem zweiten Addierer 12 seriell nachgeschaltet.

Die Ausgänge des ersten Multiplizierers 36 beziehungsweise des zweiten Multiplizierers 37 werden in einem seriell nachgeschalteten Subtrahierer 38 zusammengeführt und subtrahiert.

Der erste Addierer 11 ist ausgebildet, um den Realteil 21 des Eingangssignals 2 mit dem Realteil 13 des Trägersignals zu addieren. Am Ausgang des ersten Addierers 11 wird somit der Realteil 8 eines resultierenden modulierten Signals erhalten.

Der zweite Addierer 12 ist ausgebildet, um den Imaginärteil 22 des Eingangssignals 2 mit dem Imaginärteil 14 des Trägersignals zu addieren. Am Ausgang des zweiten Addierers 12 wird somit der Imaginärteil 9 eines resultierenden modulierten Signals erhalten.

Das Ausgangssignal des ersten Addierers 11, das heißt das digitale modulierte Signal 8 wird in dem ersten Multiplizierer 36 mit sich selbst multipliziert. Das Ausgangssignal 41 des ersten Multiplizierers 36 ist somit das Quadrat des modulierten digitalen Signals 8.

Das Ausgangssignal des zweiten Addierers 12, das heißt das digitale modulierte Signal 9 wird in dem zweiten Multiplizierer 37 mit sich selbst multipliziert. Das Ausgangssignal 42 des zweiten Multiplizierers 37 ist somit das Quadrat des modulierten digitalen Signals 9.

Das Digitalsignal 41 am Ausgang des ersten Multiplizierers 36 sowie das Digitalsignal 42 am Ausgang des zweiten Multiplizierers 37 werden in dem Subtrahierer 38 zusammengeführt. In dem vorliegenden Ausführungsbeispiel wird der Signalanteil 42 von dem Signalanteil 41 subtrahiert.

Am Ausgang des Subtrahierers 38 wird das kombinierte Digitalsignal 39 ausgegeben, welches gleichzeitig das Eingangssignal des seriell nachgeschalteten Digital-Analog-Wandlers 40 ist.

Der Digital-Analog-Wandler 40 wandelt das digitale Eingangssignal 39 in ein analoges Ausgangssignal 43, welches gleichzeitig das Eingangssignal des seriell nachgeschalteten Komparators 44 ist.

Der Komparator 44 generiert aus dem zeitkontinuierlichen Eingangssignal 43 das zeitkontinuierliche binäre Eingangssignal 4 des Leistungsverstärkers 3. Das Binärsignal 4 ist binär betreffend die Amplitude und zeitkontinuierlich. Das Binärsignal 4 dient zur Ansteuerung der Leistungskomponenten des Leistungsverstärkers 3.

Der Leistungsverstärker 3 erzeugt ein verstärktes Ausgangssignal 20, das eine verstärkte Version des binären Eingangssignals 4 ist.

Die Verstärkervorrichtung 1 weist ferner ein Rekonstruktionsfilter 18 auf. In der in Figur 5 dargestellten ersten Ausführungsform der dritten Variante handelt es sich um ein dem Leistungsverstärker 3 nachgeschaltetes Tiefpassfilter 18. Das Binärsignal 20 wird in dem Rekonstruktionsfilter 18 zu einem Ausgangssignal 23 rekonstruiert. Sei das Eingangssignal 2 gleich Z(t) und die Trägerfrequenz gleich $f_c$, so weist das Ausgangssignal 23 die folgende Signalform ohne einen weiteren Verstärkungsfaktor auf:

$$Re\{Z(t)\} * Re\{e^{j2\pi fct}\} - Im\{Z(t)\}* Im\{e^{j2\pi fct}\} = Re\{Z(t)*e^{j2\pi fct}\}$$

Gemäß der abgebildeten Ausführungsform ist also das Rekonstruktionsfilter 18 dem Leistungsverstärker 3 seriell nachgeschaltet und das Eingangssignal 20 des Rekonstruktionsfilters 18 ist das von dem Leistungsverstärker 3 erzeugte verstärkte Ausgangssignal 20. Erfindungsgemäß wird so der Außenband-Signalanteil des verstärkten Binärsignals 20 ausgefiltert.

Generell besteht das verstärkte Binärsignal 20 aus einem Inband-Signalanteil und einem Außenband-Signalanteil. Der Außenband-Signalanteil wird durch das Rekonstruktionsfilter 18 ausgefiltert. Der Inband-Signalanteil ist ausschließlich das reellwertige Ausgangssignal 23 des ganzen Systems 1. In anderen Worten ist der Inband-Signalanteil des verstärkten Binärsignals 20 eine verstärkte, mit der Trägerfrequenz fc hochmodulierte Version des Basisband-Eingangssignals 2 der gesamten erfindungsgemäßen Vorrichtung 1.

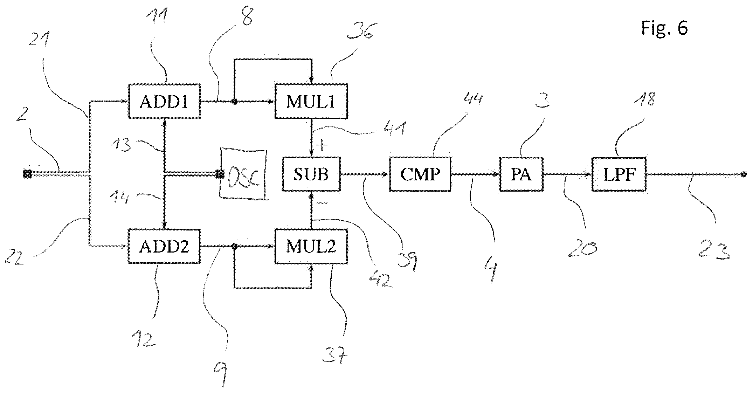

Figur 6 zeigt eine zweite Ausführungsform der erfindungsgemäßen Vorrichtung 1 gemäß der dritten Variante.

Die zweite Ausführungsform der dritten Variante entspricht im Wesentlichen der mit Bezug auf Figur 5 beschriebenen ersten Ausführungsform der dritten Variante mit dem Unterschied, dass das Eingangssignal 2 ein zeitkontinuierliches Eingangssignal ist.

Dementsprechend liegen die Signale beziehungsweise die Signalanteile 21, 22, 8, 9, 41 und 42 bereits in analoger Form vor. Somit entfällt im Vergleich zur vierten Ausführungsform der Digital-Analog-Wandler 40 in der Kombinationsvorrichtung 7. Ebenfalls entfällt die Erzeugung des analogen Ausgangssignals 43, da das Ausgangssignal 39 des Subtrahierers 38 direkt in den Komparator 44 geführt wird.

Der Komparator 44 generiert aus dem zeitkontinuierlichen Eingangssignal 39, welches hier dem Ausgangssignal des Subtrahierers 38 entspricht, das zeitkontinuierliche binäre Eingangssignal 4 des Leistungsverstärkers 3. Das Binärsignal 4 ist binär betreffend die Amplitude und zeitkontinuierlich. Das Binärsignal 4 dient zur Ansteuerung der Leistungskomponenten des Leistungsverstärkers 3.

Der Leistungsverstärker 3 erzeugt ein verstärktes Ausgangssignal 20, das eine verstärkte Version des binären Eingangssignals 4 ist. In anderen Worten ist das Ausgangssignal des ganzen Systems das verstärkte HF Signal der Trägerfrequenz $f_c$.

Die Verstärkervorrichtung 1 weist ferner ein Rekonstruktionsfilter 18 auf. In der in Figur 5 dargestellten zweiten Ausführungsform der dritten Variante handelt es sich um ein dem Leistungsverstärker 3 nachgeschaltetes Tiefpassfilter 18. Das Binärsignal 20 wird in dem Rekonstruktionsfilter 18 zu einem Ausgangssignal 23 rekonstruiert. Sei das Eingangssignal 2 gleich Z(t) und die Trägerfrequenz gleich $f_c$, so weist das Ausgangssignal 23 die folgende Signalform ohne einen weiteren Verstärkungsfaktor auf:

$$Re\{Z(t)\} * Re\{e^{j2\pi fct}\} - Im\{Z(t)\}* Im\{e^{j2\pi fct}\} = Re\{Z(t)*e^{j2\pi fct}\}$$

Gemäß der abgebildeten Ausführungsform ist also das Rekonstruktionsfilter 18 dem Leistungsverstärker 3 seriell nachgeschaltet und das Eingangssignal 20 des Rekonstruktionsfilters 18 ist das von dem Leistungsverstärker 3 erzeugte verstärkte Ausgangssignal 20. Erfindungsgemäß wird so der Außenband-Signalanteil des verstärkten Binärsignals 20 ausgefiltert.

Generell besteht das verstärkte Binärsignal 20 aus einem Inband-Signalanteil und einem Außenband-Signalanteil. Der Außenband-Signalanteil wird durch das Rekonstruktionsfilter 18 ausgefiltert. Der Inband-Signalanteil ist ausschließlich das reellwertige Ausgangssignal 23 des ganzen Systems 1. In anderen Worten ist der Inband-Signalanteil des verstärkten Binärsignals 20 eine verstärkte, mit der Trägerfrequenz fc hochmodulierte Version des Basisband-Eingangssignals 2 der gesamten erfindungsgemäßen Vorrichtung 1.

Alle beschriebenen erfindungsgemäßen Schaltverstärker-Strukturen können theoretisch entweder rein digital oder rein analog realisiert werden. Es ist jedoch sinnvoll, das System teilweise digital und analog zu betreiben.

Die Digital-Analog-Wandler 31, 32 gemäß der in Figur 4 dargestellten Ausführungsform der zweiten Variante können mit einer niedrigen Grenzfrequenz $f > f_c$ betrieben werden, während der Digital-Analog-Wandler 40 gemäß der in Figur 5 dargestellten ersten Ausführungsform der dritten Variante mit einer höheren Grenzfrequenz $f > 2f_c$ betrieben werden muss.

Das erfindungsgemäße Verstärker-System 1 gemäß der ersten Ausführungsform der ersten Variante besteht aus einem Modulationsblock 5, einem Leistungsverstärker 3 und einem Rekonstruktionsfilter 18. Der Modulationsblock 5 fasst zwei Addierer 11, 12, einen Multiplizierer 15 und einen Signalkomparator 16 zusammen. Das Eingangssignal 2 ist ein komplexwertiges Basisbandsignal und das Eingangssignal 4 des Leistungsverstärkers 3 ist ein moduliertes reellwertiges Binärsignal zur Steuerung eines Verstärkerelements, wie z.B. eines Transistors. Das Ausgangssignal 23 des ganzen Systems 1 ist das verstärkte HF Signal der Trägerfrequenz $f_c$.

Die Real- und Imaginärteile 21, 22 des Eingangssignals 2 lassen sich gemäß der Erfindung separat voneinander kodieren und verstärken.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Das erfindungsgemäße kodierte Signal kann auf einem digitalen Speichermedium gespeichert sein, oder kann auf einem Übertragungsmedium, wie beispielsweise einem drahtlosen Übertragungsmedium oder einem drahtgebundenen Übertragungsmedium, wie beispielsweise dem Internet, übertragen werden.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

**Patentansprüche**

1. Vorrichtung (1) zum Verstärken eines Eingangssignals (2), aufweisend:

   einen Leistungsverstärker (3) zum Verstärken eines binären Eingangssignals (4),
   eine Modulationsvorrichtung (5) zum Erzeugen des binären Eingangssignals (4) basierend auf dem Eingangssignal (2),
   wobei das Eingangssignal (2) ein komplexwertiges Signal ist und das binäre Eingangssignal (4) ein reellwertiges Signal ist,
   wobei die Modulationsvorrichtung (5) eine Addiervorrichtung (6) aufweist, die ausgebildet ist, um das komplexwertige Eingangssignal (2) mit einem komplexwertigen Trägersignal einer vorgegebenen Frequenz zu addieren und so ein resultierendes komplexwertiges Signal (8, 9) zu generieren, und
   wobei die Modulationsvorrichtung (5) eine der Addiervorrichtung (6) nachgeschaltete Kombinationsvorrichtung (7) aufweist, die ausgebildet ist, um aus dem Realteil (8) und dem Imaginärteil (9) des resultierenden komplexwertigen Signals (8, 9) das reellwertige binäre Eingangssignal (4) durch eine Kombination des Realteils (8) und des Imaginärteils (9) des resultierenden komplexwertigen Signals (8, 9) zu erzeugen,
   wobei die Kombinationsvorrichtung (7) einen Multiplizierer (15) zum Multiplizieren des Realteils (8) und des Imaginärteils (9) des resultierenden komplexwertigen Signals (8, 9) und einen nachgeschalteten Komparator (16) aufweist, und
   wobei die Vorrichtung (1) ein Tiefpassfilter (18) aufweist, das dem Leistungsverstärker (3) seriell nachgeschaltet ist, und das Eingangssignal (20) des Tiefpassfilters (18) das von dem Leistungsverstärker (3) erzeugte verstärkte Ausgangssignal (20) ist.

2. Vorrichtung (1) nach Anspruch 1, wobei das komplexwertige Eingangssignal (2) ein analoges Signal ist, und die Vorrichtung (1) einen analogen Oszillator (19) zum Erzeugen des komplexwertigen Trägersignals (13, 14) aufweist.

3. Vorrichtung (1) nach einem der vorhergehenden Ansprüche, wobei der Multiplizierer (15) ausgebildet ist, um den Realteil (8) und den Imaginärteil (9) des resultierenden komplexwertigen analogen Signals (8, 9) miteinander zu einem analogen kombinierten Signal (17) zu kombinieren, und wobei der Komparator (16) ausgebildet ist, um dieses analoge kombinierte Signal (17) in das binäre zeitkontinuierliche Eingangssignal (4) des Leistungsverstärkers (3) zu wandeln.

4. Vorrichtung (1) nach Anspruch 1, wobei das komplexwertige Eingangssignal (2) ein digitales Signal ist, und die Vorrichtung (1) einen digitalen Oszillator (19) zum Erzeugen des komplexwertigen Trägersignals (13, 14) aufweist.

5. Vorrichtung (1) nach Anspruch 4, wobei die Kombinationsvorrichtung (8) einen zwischen dem Multiplizierer (15) und dem Komparator (16) angeordneten Digital-Analog-Wandler (24) aufweist, wobei der Multiplizierer (15) ausgebildet ist, um den Realteil (8) und den Imaginärteil (9) des resultierenden modulierten komplexwertigen digitalen Signals (8, 9) miteinander zu einem digitalen Ausgangssignal (17) zu kombinieren, wobei der Digital-Analog-Wandler (24) ausgebildet ist, um das digitale Ausgangssignal (17) des Multiplizierers (15) in ein analoges Signal (25) zu wandeln, und wobei der Komparator (16) ausgebildet ist, um das analoge Ausgangssignal (25) des Digital-Analog-Wandlers (24) in das binäre zeitkontinuierliche Eingangssignal (4) des Leistungsverstärkers (3) zu wandeln.

6. Vorrichtung (1) zum Verstärken eines Eingangssignals (2), aufweisend:

einen Leistungsverstärker (3) zum Verstärken eines binären Eingangssignals (4),

eine Modulationsvorrichtung (5) zum Erzeugen des binären Eingangssignals (4) basierend auf dem Eingangssignal (2),

wobei das Eingangssignal (2) ein komplexwertiges Signal ist und das binäre Eingangssignal (4) ein reellwertiges Signal ist,

wobei die Modulationsvorrichtung (5) eine Addiervorrichtung (6) aufweist, die ausgebildet ist, um das komplexwertige Eingangssignal (2) mit einem komplexwertigen Trägersignal einer vorgegebenen Frequenz zu addieren und so ein resultierendes komplexwertiges Signal (8, 9) zu generieren, und

wobei die Modulationsvorrichtung (5) eine der Addiervorrichtung (6) nachgeschaltete Kombinationsvorrichtung (7) aufweist, die ausgebildet ist, um aus dem Realteil (8) und dem Imaginärteil (9) des resultierenden komplexwertigen Signals (8, 9) das reellwertige binäre Eingangssignal (4) durch eine Kombination des Realteils (8) und des Imaginärteils (9) des resultierenden komplexwertigen Signals (8, 9) zu erzeugen,

wobei die Kombinationsvorrichtung (7) einen ersten Komparator (33) zum Verarbeiten des Realteils (8) und einen zweiten Komparator (34) zum Verarbeiten des Imaginärteils (9) des resultierenden komplexwertigen Signals (8, 9) sowie ein den ersten und zweiten Komparatoren (33, 34) seriell nachgeschaltetes XOR-Gatter (35) zum Zusammenführen der Ausgangssignale (28, 29) der ersten und zweiten Komparatoren (33, 34) aufweist, und

wobei die Vorrichtung (1) ein Tiefpassfilter (18) aufweist, das dem Leistungsverstärker (3) seriell nachgeschaltet ist, und das Eingangssignal (20) des Tiefpassfilters (18) das von dem Leistungsverstärker (3) erzeugte verstärkte Ausgangssignal (20) ist.

7. Vorrichtung (1) nach Anspruch 6, wobei die Kombinationsvorrichtung (7) einen ersten und einen zweiten Digital-Analog-Wandler (31, 32) aufweist, wobei der erste Digital-Analog-Wandler (31) dem ersten Addierer (11) seriell nachgeschaltet ist und dazu ausgebildet ist, um den Realteil (8) des digitalen resultierenden Signals (8, 9) in ein analoges reellwertiges Signal (26) zu wandeln, und wobei der zweite Digital-Analog-Wandler (32) dem zweiten Addierer (12) seriell nachgeschaltet ist und dazu ausgebildet ist, um den Imaginärteil (9) des digitalen resultierenden Signals (8, 9) in ein analoges Signal (27) zu wandeln.

8. Vorrichtung (1) nach Anspruch 7, wobei der erste Komparator (33) dem ersten Digital-Analog-Wandler (31) seriell nachgeschaltet ist, und der zweite Komparator (34) dem zweiten Digital-Analog-Wandler (32) seriell nachgeschaltet ist, und wobei der erste Komparator (33) ausgebildet ist, um den Realteil (26) des analogen resultierenden Signals in ein erstes reellwertiges binäres zeitkontinuierliches Signal (28) zu wandeln, und wobei der zweite Komparator (34) ausgebildet ist, um den Imaginärteil (27) des analogen resultierenden Signals in ein zweites reellwertiges binäres zeitkontinuierliches Signal (29) zu wandeln.

9. Vorrichtung (1) nach Anspruch 8, wobei das XOR-Gatter (35) ausgebildet ist, um das aus dem Realteil resultierende erste reellwertige binäre zeitkontinuierliche Signal (28) und das aus dem Imaginärteil resultierende zweite reellwertige binäre zeitkontinuierliche Signal (29) logisch miteinander derart zu verknüpfen, dass das Ausgangssignal des XOR-Gatters (35) das binäre zeitkontinuierliche Eingangssignal (4) des Leistungsverstärkers (3) ist.

10. Vorrichtung (1) zum Verstärken eines Eingangssignals (2), aufweisend:

einen Leistungsverstärker (3) zum Verstärken eines binären Eingangssignals (4),

eine Modulationsvorrichtung (5) zum Erzeugen des binären Eingangssignals (4) basierend auf dem Eingangssignal (2),

wobei das Eingangssignal (2) ein komplexwertiges Signal ist und das binäre Eingangssignal (4) ein reellwertiges Signal ist,

wobei die Modulationsvorrichtung (5) eine Addiervorrichtung (6) aufweist, die ausgebildet ist, um das komplexwertige Eingangssignal (2) mit einem komplexwertigen Trägersignal einer vorgegebenen Frequenz zu addieren und so ein resultierendes komplexwertiges Signal (8, 9) zu generieren, und

wobei die Modulationsvorrichtung (5) eine der Addiervorrichtung (6) nachgeschaltete Kombinationsvorrichtung (7) aufweist, die ausgebildet ist, um aus dem Realteil (8) und dem Imaginärteil (9) des resultierenden komplexwertigen Signals (8, 9) das reellwertige binäre Eingangssignal (4) durch eine Kombination des Realteils (8) und des Imaginärteils (9) des resultierenden komplexwertigen Signals (8, 9) zu erzeugen,

wobei die Kombinationsvorrichtung (7) einen ersten und einen zweiten Multiplizierer (36, 37) aufweist, wobei der erste Multiplizierer (36) dem ersten Addierer (11) seriell nachgeschaltet ist, und der zweite Multiplizierer (37) dem zweiten Addierer (12) seriell nachgeschaltet ist, und wobei der erste Multiplizierer (36) ausgebildet ist, um ein aus dem Realteil gebildetes zeitdiskretes Ausgangssignal (8) des ersten Addierers (11) zeitlich mit sich selbst zu multiplizieren, und wobei der zweite Multiplizierer (37) ausgebildet ist, um ein aus dem Imaginärteil gebildetes zeitdiskretes Ausgangssignal (9) des zweiten Addierers (12) zeitlich mit sich selbst zu multiplizieren, und

wobei die Vorrichtung (1) ein Tiefpassfilter (18) aufweist, das dem Leistungsverstärker (3) seriell nachgeschaltet ist, und das Eingangsignal (20) des Tiefpassfilters (18) das von dem Leistungsverstärker (3) erzeugte verstärkte Ausgangssignal (20) ist.

11. Vorrichtung (1) nach Anspruch 10, wobei die Kombinationsvorrichtung (7) einen den beiden Multiplizierern (36, 37) nachgeschalteten Subtrahierer (38) aufweist, der ausgebildet ist, um eine Differenz aus dem Quadrat des Realteils (8) und dem Quadrat des Imaginärteils (9) zu bilden, so dass ein reellwertiges digitales Ausgangssignal (39) erzeugt wird.

12. Vorrichtung nach Anspruch 11, wobei die Kombinationsvorrichtung (7) einen dem Subtrahierer (38) seriell nachgeschalteten Komparator (44) und einen zwischen dem Subtrahierer (38) und dem Komparator (44) angeordneten Digital-Analog-Wandler (40) aufweist, wobei der Digital-Analog-Wandler (40) dazu ausgebildet ist, um das reellwertige digitale Ausgangssignal (39) des Subtrahierers (38) in ein analoges Signal (43) zu wandeln, und wobei der Komparator (44) dazu ausgebildet ist, um das analoge Ausgangssignal (43) des Digital-Analog-Wandlers (40) in das binäre Eingangsignal (4) des Leistungsverstärkers (3) zu wandeln.

13. Vorrichtung (1) nach Anspruch 10, wobei die Kombinationsvorrichtung (7) einen den beiden Multiplizierern (36, 37) nachgeschalteten Subtrahierer (38) aufweist, der ausgebildet ist, um eine Differenz aus dem Quadrat des Realteils (8) und dem Quadrat des Imaginärteils (9) zu bilden, so dass ein reellwertiges analoges Ausgangssignal (39) erzeugt wird.

14. Vorrichtung nach Anspruch 13, wobei die Kombinationsvorrichtung (7) einen dem Subtrahierer (38) seriell nachgeschalteten Komparator (44) aufweist, wobei der Komparator (44) dazu ausgebildet ist, um das analoge Ausgangssignal (39) in das binäre Eingangsignal (4) des Leistungsverstärkers (3) zu wandeln.

15. Vorrichtung (1) nach einem der vorhergehenden Ansprüche, wobei die Addiervorrichtung (6) einen ersten Addierer (11) und einen zweiten Addierer (12) aufweist, wobei der erste Addierer (11) ausgebildet ist, um den Realteil (21) des Eingangsignals (2) mit dem Realteil (13) des Trägersignals (13, 14) zu einem Realteil (8) des resultierenden Signals (8, 9) zu kombinieren, und wobei der zweite Addierer (12) ausgebildet ist, um den Imaginärteil (22) des Eingangsignals (2) mit dem Imaginärteil (14) des Trägersignals (13, 14) zu einem Imaginärteil (9) des resultierenden Signals (8, 9) zu kombinieren.

16. Verfahren zum Verstärken eines Eingangsignals (2) mit den folgenden Schritten:

Verstärken eines binären Eingangsignals (4), sodass ein verstärktes Ausgangssignal (20) erzeugt wird, Erzeugen des binären Eingangsignals (4) basierend auf dem Eingangsignal (2), wobei das Eingangsignal (2) ein komplexwertiges Eingangsignal ist und das binäre Eingangsignal (4) ein reellwertiges Signal ist, Addieren des komplexwertigen Eingangsignals (2) mit einem komplexwertigen Trägersignal (13, 14) einer vorgegebenen Frequenz ($f_C$) zum Generieren eines resultierenden komplexwertigen Signals (8, 9), und Erzeugen des reellwertigen binären Eingangsignals (4) aus dem Realteil (8) und dem Imaginärteil (9) des resultierenden komplexwertigen Signals (8, 9) durch eine Multiplikation des Realteils (8) und des Imaginärteils (9) des resultierenden komplexwertigen Signals (8, 9) und Zuführen des resultierenden komplexwertigen Signals (8, 9) zu einem nachgeschalteten Komparator (16), und tiefpassfiltern des erzeugten verstärkten Ausgangssignals (20) zum Ausfiltern des Außenband-Signalanteils des verstärkten Ausgangssignals (20).

17. Verfahren nach Anspruch 16, wobei das komplexwertige Eingangsignal (2) ein analoges Signal ist, und wobei die Multiplikation des Realteils (8) und des Imaginärteils (9) des resultierenden komplexwertigen analogen Signals (8, 9) ein analoges kombiniertes Signal (17) ergibt, und wobei dieses analoge kombinierte Signal (17) mittels des Komparators (16) in das binäre zeitkontinuierliche Eingangsignal (4) des Leistungsverstärkers (3) zu wandeln.

18. Verfahren nach Anspruch 16, wobei das komplexwertige Eingangsignal (2) ein digitales Signal ist, und wobei der Realteil (8) und der Imaginärteil (9) mittels der Multiplikation zu einem digitalen Ausgangssignal (17) kombiniert werden, wobei das digitale Ausgangssignal (17) nach dem Multiplizieren in ein analoges Signal (25) gewandelt wird, und wobei das analoge Signal (25) mittels des Komparators (16) in das binäre zeitkontinuierliche Eingangsignal

(4) des Leistungsverstärkers (3) gewandelt wird.

**19.** Verfahren zum Verstärken eines Eingangssignals (2) mit den folgenden Schritten:

Verstärken eines binären Eingangssignals (4), sodass ein verstärktes Ausgangssignal (20) erzeugt wird,
Erzeugen des binären Eingangssignals (4) basierend auf dem Eingangssignal (2), wobei das Eingangssignal (2) ein komplexwertiges Eingangssignal ist und das binäre Eingangssignal (4) ein reellwertiges Signal ist,
Addieren des komplexwertigen Eingangssignals (2) mit einem komplexwertigen Trägersignal (13, 14) einer vorgegebenen Frequenz ($f_c$) zum Generieren eines resultierenden komplexwertigen Signals (8, 9), und
Erzeugen des reellwertigen binären Eingangssignals (4) aus dem Realteil (8) und dem Imaginärteil (9) des resultierenden komplexwertigen Signals (8, 9) durch eine Kombination des Realteils (8) und des Imaginärteils (9) des resultierenden komplexwertigen Signals (8, 9), wobei der Realteil (8) mittels eines ersten Komparators (33) und der Imaginärteil (9) mittels einen zweiten Komparators (34) verarbeitet und in einem seriell nachgeschalteten XOR-Gatter (35) zusammengeführt werden, und
tiefpassfiltern des erzeugten verstärkten Ausgangssignals (20) zum Ausfiltern des Außenband-Signalanteils des verstärkten Ausgangssignals (20).

**20.** Verfahren zum Verstärken eines Eingangssignals (2) mit den folgenden Schritten:

Verstärken eines binären Eingangssignals (4), sodass ein verstärktes Ausgangssignal (20) erzeugt wird,
Erzeugen des binären Eingangssignals (4) basierend auf dem Eingangssignal (2), wobei das Eingangssignal (2) ein komplexwertiges Eingangssignal ist und das binäre Eingangssignal (4) ein reellwertiges Signal ist,
Addieren des komplexwertigen Eingangssignals (2) mit einem komplexwertigen Trägersignal (13, 14) einer vorgegebenen Frequenz ($f_c$) zum Generieren eines resultierenden komplexwertigen Signals (8, 9),
wobei nach dem Addieren ein aus dem Realteil gebildetes zeitdiskretes Ausgangssignal (8) zeitlich mit sich selbst multipliziert wird, und nach dem Addieren ein aus dem Imaginärteil gebildetes zeitdiskretes Ausgangssignal (9) zeitlich mit sich selbst multipliziert wird,
Erzeugen des reellwertigen binären Eingangssignals (4) aus dem mit sich selbst multiplizierten Realteil (8) und dem mit sich selbst multiplizierten Imaginärteil (9) des resultierenden komplexwertigen Signals (8, 9) durch eine Kombination des mit sich selbst multiplizierten Realteils (8) und des mit sich selbst multiplizierten Imaginärteils (9) des resultierenden komplexwertigen Signals (8, 9), und
tiefpassfiltern des erzeugten verstärkten Ausgangssignals (20) zum Ausfiltern des Außenband-Signalanteils des verstärkten Ausgangssignals (20).

**21.** Verfahren nach Anspruch 20, wobei der mit sich selbst multiplizierte Realteil (8) und der mit sich selbst multiplizierte Imaginärteil (9) subtrahiert werden, um eine Differenz aus dem Quadrat des Realteils (8) und dem Quadrat des Imaginärteils (9) zu bilden, so dass ein reellwertiges digitales Ausgangssignal (39) erzeugt wird.

**22.** Verfahren nach Anspruch 20, wobei der mit sich selbst multiplizierte Realteil (8) und der mit sich selbst multiplizierte Imaginärteil (9) subtrahiert werden, um eine Differenz aus dem Quadrat des Realteils (8) und dem Quadrat des Imaginärteils (9) zu bilden, so dass ein reellwertiges analoges Ausgangssignal (39) erzeugt wird.

**Claims**

**1.** Device (1) for amplifying an input signal (2), comprising:

a power amplifier (3) for amplifying a binary input signal (4),
a modulation device (5) for generating the binary input signal (4) on the basis of the input signal (2),
the input signal (2) being a complex-valued signal and the binary input signal (4) being a real-valued signal,
the modulation device (5) comprising an adding device (6) configured to add the complex-valued input signal (2) to a complex-valued carrier signal of a predefined frequency and to thus generate a resulting complex-valued signal (8, 9), and
the modulation device (5) comprising a combination device (7) connected downstream from the adding device (6) and configured to generate the real-valued binary input signal (4) from the real part (8) and the imaginary part (9) of the resulting complex-valued signal (8, 9) by combining the real part (8) and the imaginary part (9) of the resulting complex-valued signal (8, 9),
the combination device (7) comprising a multiplier (15) for multiplying the real part (8) and the imaginary part (9) of the resulting complex-valued signal (8, 9) and a comparator (16) connected downstream.
the device (1) comprising a low-pass filter (18) being serially connected downstream from the power amplifier (3), and the input signal (20) of the low-pass filter (18) being the amplified output signal (20) generated by the power amplifier (3).

2. Device (1) as claimed in claim 1, wherein the complex-valued input signal (2) is an analog signal and the device (1) comprises an analog oscillator (19) for generating the complex-valued carrier signal (13, 14).

3. Device (1) as claimed in any of the previous claims, the multiplier (15) being configured to combine the real part (8) and the imaginary part (9) of the resulting complex-valued analog signal (8, 9) to form an analog combined signal (17), and the comparator (16) being configured to convert said analog combined signal (17) to the binary time-continuous input signal (4) of the power amplifier (3).

4. Device (1) as claimed in claim 1, wherein the complex-valued input signal (2) is a digital signal, and the device (1) comprises a digital oscillator (19) for generating the complex-valued carrier signal (13, 14).

5. Device (1) as claimed in claim 4, wherein the combination device (8) comprises a a digital-to-analog converter (24) arranged between the multiplier (15) and the comparator (16), the multiplier (15) being configured to combine the real part (8) and the imaginary part (9) of the resulting modulated complex-valued digital signal (8, 9) to form a digital output signal (17), the digital-to-analog converter (24) being configured to convert the digital output signal (17) of the multiplier (15) to an analog signal (25), and the comparator (16) being configured to convert the analog output signal (25) of the digital-to-analog converter (24) to the binary time-continuous input signal (4) of the power amplifier (3).

6. Device (1) for amplifying an input signal (2), comprising:

a power amplifier (3) for amplifying a binary input signal (4),
a modulation device (5) for generating the binary input signal (4) on the basis of the input signal (2),
the input signal (2) being a complex-valued signal and the binary input signal (4) being a real-valued signal,
the modulation device (5) comprising an adding device (6) configured to add the complex-valued input signal (2) to a complex-valued carrier signal of a predefined frequency and to thus generate a resulting complex-valued signal (8, 9), and
the modulation device (5) comprising a combination device (7) connected downstream from the adding device (6) and configured to generate the real-valued binary input signal (4) from the real part (8) and the imaginary part (9) of the resulting complex-valued signal (8, 9) by combining the real part (8) and the imaginary part (9) of the resulting complex-valued signal (8, 9),
the combination device (7) further comprising a first comparator (33) for processing the real part (8) and a second comparator (34) for processing the imaginary part (9) of the resulting complex-valued signal (8, 9) and a logical XOR gate (35) serially connected downstream from the first and second comparators (33, 34) for linking the output signals (28, 29) of the first and second comparators (33, 34),
the device (1) comprising a low-pass filter (18) being serially connected downstream from the power amplifier (3), and the input signal (20) of the low-pass filter (18) being the amplified output signal (20) generated by the power amplifier (3).

7. Device (1) as claimed in claim 6, wherein the combination device (7) comprises first and second digital-to-analog converter (31, 32), the first digital-to-analog converter (31) being serially connected downstream from the first adder (11) and configured to convert the real part (8) of the digital resulting signal (8, 9) to an analog real-valued signal (26), and the second digital-to-analog converter (32) being serially connected downstream from the second adder (12) and configured to convert the imaginary part (9) of the digital resulting signal (8, 9) to an analog signal (27).

8. Device (1) as claimed in claim 7, the first comparator (33) being serially connected downstream from the first digital-to-analog converter (31) and the second comparator (34) being serially connected downstream from the second digital-to-analog converter (32), and the first comparator (33) being configured to convert the real part (26) of the analog resulting signal to a first real-valued binary time-continuous signal (28), and the second comparator (34) being configured to convert the imaginary part (27) of the analog resulting signal to a second real-valued binary time-continuous signal (29).

9. Device (1) as claimed in claim 8, wherein the XOR gate (35) is configured to logically link the first real-valued binary

**EP 3 076 544 B1**

time-continuous signal (28) resulting from the real part and the second real-valued binary time-continuous signal (29) resulting from the imaginary part with each other such that the output signal of the XOR gate (35) is the binary time-continuous input signal (4) of the power amplifier (3).

10. Device (1) for amplifying an input signal (2), comprising:

a power amplifier (3) for amplifying a binary input signal (4),
a modulation device (5) for generating the binary input signal (4) on the basis of the input signal (2),
the input signal (2) being a complex-valued signal and the binary input signal (4) being a real-valued signal,
the modulation device (5) comprising an adding device (6) configured to add the complex-valued input signal (2) to a complex-valued carrier signal of a predefined frequency and to thus generate a resulting complex-valued signal (8, 9), and
the modulation device (5) comprising a combination device (7) connected downstream from the adding device (6) and configured to generate the real-valued binary input signal (4) from the real part (8) and the imaginary part (9) of the resulting complex-valued signal (8, 9) by combining the real part (8) and the imaginary part (9) of the resulting complex-valued signal (8, 9),
wherein the combination device (7) comprises first and second multipliers (36, 37), the first multiplier (36) being serially connected downstream from the first adder (11), and the second multiplier (37) being serially connected downstream from the second adder (12), and the first multiplier (36) being configured to temporally multiply a time-discrete output signal (8), formed from the real part, of the first adder (11) by itself, and the second multiplier (37) being configured to temporally multiply a time-discrete output signal (9), formed from the imaginary part, of the second adder (12) by itself, and
the device (1) comprising a low-pass filter (18) being serially connected downstream from the power amplifier (3), and the input signal (20) of the low-pass filter (18) being the amplified output signal (20) generated by the power amplifier (3).

11. Device (1) as claimed in claim 10, wherein the combination device (7) comprises a subtractor (38) connected downstream from both multipliers (36, 37) and configured to form a difference from the square of the real part (8) and the square of the imaginary part (9), so that a real-valued digital output signal (39) is generated.

12. Device as claimed in claim 11, wherein the combination device (7) comprises a comparator (44) serially connected downstream from the subtractor (38) and a digital-to-analog converter (40) arranged between the subtractor (38) and the comparator (44), the digital-to-analog converter (40) being configured to convert the real-valued digital output signal (39) of the subtractor (38) to an analog signal (43), and the comparator (44) being configured to convert the analog output signal (43) of the digital-to-analog converter (40) to the binary input signal (4) of the power amplifier (3).

13. Device (1) as claimed in claim 10, wherein the combination device (7) comprises a subtractor (38) connected downstream from both multipliers (36, 37) and configured to form a difference from the square of the real part (8) and the square of the imaginary part (9), so that a real-valued analog output signal (39) is generated.

14. Device as claimed in claim 13, wherein the combination device (7) comprises a comparator (44) serially connected downstream from the subtractor (38), the comparator (44) being configured to convert the analog output signal (39) into the binary input signal (4) of the power amplifier (3).

15. Device (1) as claimed in any one of the preceding claims, wherein the adding device (6) comprises a first adder (11) and a second adder (12), the first adder (11) being configured to combine the real part (21) of the input signal (2) with the real part (13) of the carrier signal (13, 14) to form a real part (8) of the resulting signal (8, 9), and the second adder (12) being configured to combine the imaginary part (22) of the input signal (2) with the imaginary part (14) of the carrier signal (13, 14) to form an imaginary part (9) of the resulting signal (8, 9).

16. Method of amplifying an input signal (2), comprising:

amplifying a binary input signal (4) such that an amplified output signal (20) is generated,
generating the binary input signal (4) on the basis of the input signal (2), the input signal (2) being a complex-valued input signal and the binary input signal (4) being a real-valued signal,
adding the complex-valued input signal (2) to a complex-valued carrier signal (13, 14) of a predefined frequency $(f_c)$ for generating a resulting complex-valued signal (8, 9), and

16

generating the real-valued binary input signal (4) from the real part (8) and the imaginary part (9) of the resulting complex-valued signal (8, 9) by multiplying the real part (8) and the imaginary part (9) of the resulting complex-valued signal (8, 9) and feeding the resulting complex-valued signal (8, 9) into a comparator (16) connected downstream, and low-pass filtering the generated amplified output signal (20) for filtering out the out-of-band signal portion of the amplified output signal (20).

17. Method as claimed in claim 16, wherein the complex-valued input signal (2) is an analog signal, and wherein multiplying the real part (8) and the imaginary part (9) of the resulting complex-valued analog signal (8, 9) results in an analog combined signal (17), and wherein this analog combined signal (17) is converted into the binary time-continuous input signal (4) of the power amplifier (3) by means of the comparator (16).

18. Method as claimed in claim 16, wherein the complex-valued input signal (2) is a digital signal, and wherein the real part (8) and the imaginary part (9) are combined into a digital output signal (17) by means of the multiplication, wherein the digital output signal (17) is converted into an analog signal (25) after the multiplication, and wherein the analog signal (25) is converted into the binary time-continuous input signal (4) of the power amplifier (3) by means of the comparator (16).

19. Method of amplifying an input signal (2), comprising:

amplifying a binary input signal (4) such that an amplified output signal (20) is generated,
generating the binary input signal (4) on the basis of the input signal (2), the input signal (2) being a complex-valued input signal and the binary input signal (4) being a real-valued signal,
adding the complex-valued input signal (2) to a complex-valued carrier signal (13, 14) of a predefined frequency ($f_c$) for generating a resulting complex-valued signal (8, 9), and
generating the real-valued binary input signal (4) from the real part (8) and the imaginary part (9) of the resulting complex-valued signal (8, 9) by a combination the real part (8) and the imaginary part (9) of the resulting complex-valued signal (8, 9), wherein the real part (8) is processed by means of a first comparator (33) and the imaginary part (9) is processed by means of a second comparator (34) and wherein the two are linked in a XOR gate (35) serially connected downstream, and
low-pass filtering the generated amplified output signal (20) for filtering out the out-of-band signal portion of the amplified output signal (20).

20. Method of amplifying an input signal (2), comprising:

amplifying a binary input signal (4) such that an amplified output signal (20) is generated,
generating the binary input signal (4) on the basis of the input signal (2), the input signal (2) being a complex-valued input signal and the binary input signal (4) being a real-valued signal,
adding the complex-valued input signal (2) to a complex-valued carrier signal (13, 14) of a predefined frequency ($f_c$) for generating a resulting complex-valued signal (8, 9), and
wherein, after adding, a time-discrete output signal (8) formed from the real part is temporally multiplied with itself, and, after adding, a time-discrete output signal (9) formed from the imaginary part is temporally multiplied with itself,
generating the real-valued binary input signal (4) from the self-multiplied real part (8) and the self-multiplied imaginary part (9) of the resulting complex-valued signal (8, 9) by a combination of the self-multiplied real part (8) and the self-multiplied imaginary part (9) of the resulting complex-valued signal (8, 9), and
low-pass filtering the generated amplified output signal (20) for filtering out the out-of-band signal portion of the amplified output signal (20).

21. Method according to claim 20, wherein the self-multiplied real part (8) and the self-multiplied imaginary part (9) are subtracted to form a difference from the square of the real part (8) and the square of the imaginary part (9), so that a real-valued digital output signal (39) is generated.

22. Method according to claim 20, wherein the self-multiplied real part (8) and the self-multiplied imaginary part (9) are subtracted to form a difference from the square of the real part (8) and the square of the imaginary part (9), so that a real-valued analog output signal (39) is generated.

**Revendications**

1. Dispositif (1) pour amplifier un signal d'entrée (2), présentant:

   un amplificateur de puissance (3) destiné à amplifier un signal d'entrée binaire (4),
   un dispositif de modulation (5) destiné à générer le signal d'entrée binaire (4) sur base du signal d'entrée (2),
   dans lequel le signal d'entrée (2) est un signal de valeur complexe et le signal d'entrée binaire (4) est un signal de valeur réelle,
   dans lequel le dispositif de modulation (5) présente un dispositif d'addition (6) qui est conçu pour additionner le signal d'entrée de valeur complexe (2) avec un signal porteur de valeur complexe d'une fréquence prédéterminée et pour générer ainsi un signal de valeur complexe résultant (8, 9), et
   dans lequel le dispositif de modulation (5) présente un dispositif de combinaison (7) connecté en aval du dispositif d'addition (6) qui est conçu pour générer, à partir de la partie réelle (8) et de la partie imaginaire (9) du signal de valeur complexe résultant (8, 9), le signal d'entrée binaire de valeur réelle (4) par une combinaison de la partie réelle (8) et de la partie imaginaire (9) du signal de valeur complexe résultant (8, 9),
   dans lequel le dispositif de combinaison (7) présente un multiplicateur (15) destiné à multiplier la partie réelle (8) et la partie imaginaire (9) du signal de valeur complexe résultant (8, 9) et un comparateur (16) connecté en aval, et
   dans lequel le dispositif (1) comprend un filtre passe-bas (18) qui est connecté en série en aval de l'amplificateur de puissance (3), et le signal d'entrée (20) du filtre passe-bas (18) est le signal de sortie (20) amplifié généré par l'amplificateur de puissance (3).

2. Dispositif (1) selon la revendication 1, dans lequel le signal d'entrée de valeur complexe (2) est un signal analogique, et le dispositif (1) présente un oscillateur analogique (19) destiné à générer le signal porteur de valeur complexe (13, 14).

3. Dispositif (1) selon l'une des revendications précédentes, dans lequel le multiplicateur (15) est conçu pour combiner la partie réelle (8) et la partie imaginaire (9) du signal analogique de valeur complexe résultant (8, 9) l'un avec l'autre pour obtenir un signal combiné analogique (17), et dans lequel le comparateur (16) est conçu pour convertir ce signal analogique combiné (17) en signal d'entrée binaire continu dans le temps (4) de l'amplificateur de puissance (3).

4. Dispositif (1) selon la revendication 1, dans lequel le signal d'entrée de valeur complexe (2) est un signal numérique, et le dispositif (1) présente un oscillateur numérique (19) destiné à générer le signal porteur de valeur complexe (13, 14).

5. Dispositif (1) selon la revendication 4, dans lequel le dispositif de combinaison (8) présente un convertisseur numérique-analogique (24) disposé entre le multiplicateur (15) et le comparateur (16), dans lequel le multiplicateur (15) est conçu pour combiner la partie réelle (8) et la partie imaginaire (9) du signal numérique de valeur complexe modulé résultant (8, 9) l'une avec l'autre pour obtenir un signal de sortie numérique (17), dans lequel le convertisseur numérique-analogique (24) est conçu pour convertir le signal de sortie numérique (17) du multiplicateur (15) en un signal analogique (25), et dans lequel le comparateur (16) est conçu pour convertir le signal de sortie analogique (25) du convertisseur numérique-analogique (24) en signal d'entrée binaire continu dans le temps (4) de l'amplificateur de puissance (3).

6. Dispositif (1) pour amplifier un signal d'entrée (2), présentant:

   un amplificateur de puissance (3) destiné à amplifier un signal d'entrée binaire (4),
   un dispositif de modulation (5) destiné à générer le signal d'entrée binaire (4) sur base du signal d'entrée (2),
   dans lequel le signal d'entrée (2) est un signal de valeur complexe et le signal d'entrée binaire (4) est un signal de valeur réelle,
   dans lequel le dispositif de modulation (5) présente un dispositif d'addition (6) qui est conçu pour additionner le signal d'entrée de valeur complexe (2) avec un signal porteur de valeur complexe d'une fréquence prédéterminée et pour générer ainsi un signal de valeur complexe résultant (8, 9), et
   dans lequel le dispositif de modulation (5) présente un dispositif de combinaison (7) connecté en aval du dispositif d'addition (6) qui est conçu pour générer, à partir de la partie réelle (8) et de la partie imaginaire (9) du signal de valeur complexe résultant (8, 9), le signal d'entrée binaire de valeur réelle (4) par une combinaison de la partie réelle (8) et de la partie imaginaire (9) du signal de valeur complexe résultant (8, 9),

dans lequel le dispositif de combinaison (7) présente un premier comparateur (33) destiné à traiter la partie réelle (8) et un deuxième comparateur (34) destiné à traiter la partie imaginaire (9) du signal de valeur complexe résultant (8, 9) ainsi qu'une grille XOR (35) connectée en série en aval des premier et deuxième comparateurs (33, 34) et destinée à unir les signaux de sortie (28, 29) des premier et deuxième comparateurs (33, 34), et dans lequel le dispositif (1) comprend un filtre passe-bas (18) qui est connecté en série en aval de l'amplificateur de puissance (3), et le signal d'entrée (20) du filtre passe-bas (18) est le signal de sortie (20) amplifié généré par l'amplificateur de puissance (3).

7.  Dispositif (1) selon la revendication 6, dans lequel le dispositif de combinaison (7) présente un premier et un deuxième convertisseur numérique-analogique (31, 32), dans lequel le premier convertisseur numérique-analogique (31) est connecté en série en aval du premier additionneur (11) et est conçu pour convertir la partie réelle (8) du signal numérique résultant (8, 9) en un signal analogique de valeur réelle (26), et dans lequel le deuxième convertisseur numérique-analogique (32) est connecté en série en aval du deuxième additionneur (12) et est conçu pour convertir la partie imaginaire (9) du signal numérique résultant (8, 9) en un signal analogique (27).

8.  Dispositif (1) selon la revendication 7, dans lequel le premier comparateur (33) est connecté en série en aval du premier convertisseur numérique-analogique (31) et le deuxième comparateur (34) est connecté en série en aval du deuxième convertisseur numérique-analogique (32), et dans lequel le premier comparateur (33) est conçu pour convertir la partie réelle (26) du signal analogique résultant en un premier signal binaire de valeur réelle continu dans le temps (28), et dans lequel le deuxième comparateur (34) est conçu pour convertir la partie imaginaire (27) du signal analogique résultant en un deuxième signal binaire de valeur réelle continu dans le temps (29).

9.  Dispositif (1) selon la revendication 8, dans lequel la grille XOR (35) est conçue pour coupler logiquement le premier signal binaire de valeur réelle continu dans le temps (28) résultant de la partie réelle et le deuxième signal binaire continu de valeur réelle dans le temps (29) résultant de la partie imaginaire de sorte que le signal de sortie de la grille XOR (35) soit le signal d'entrée binaire continu dans le temps (4) de l'amplificateur de puissance (3).

10. Dispositif (1) pour amplifier un signal d'entrée (2), présentant:

   un amplificateur de puissance (3) destiné à amplifier un signal d'entrée binaire (4), un dispositif de modulation (5) destiné à générer le signal d'entrée binaire (4) sur base du signal d'entrée (2), dans lequel le signal d'entrée (2) est un signal de valeur complexe et le signal d'entrée binaire (4) est un signal de valeur réelle, dans lequel le dispositif de modulation (5) présente un dispositif d'addition (6) conçu pour additionner le signal d'entrée de valeur complexe (2) avec un signal porteur de valeur complexe d'une fréquence prédéterminée et pour générer ainsi un signal de valeur complexe résultant (8, 9), et dans lequel le dispositif de modulation (5) présente un dispositif de combinaison (7) connecté en aval du dispositif d'addition (6) qui est conçu pour générer, à partir de la partie réelle (8) et de la partie imaginaire (9) du signal de valeur complexe résultant (8, 9), le signal d'entrée binaire de valeur réelle (4) par une combinaison de la partie réelle (8) et de la partie imaginaire (9) du signal de valeur complexe résultant (8, 9), dans lequel le dispositif de combinaison (7) présente un premier et un deuxième multiplicateur (36, 37), dans lequel le premier multiplicateur (36) est connecté en série en aval du premier additionneur (11), et le deuxième multiplicateur (37)) est connecté en série en aval du deuxième additionneur (12), et dans lequel le premier multiplicateur (36) est conçu pour multiplier un signal de sortie discret dans le temps (8) du premier additionneur (11) formé à partir de la partie réelle temporellement par lui-même, et dans lequel le deuxième multiplicateur (37) est conçu pour multiplier un signal de sortie discret dans le temps (9) du deuxième additionneur (12) formé à partir de la partie imaginaire temporellement par lui-même, et dans lequel le dispositif (1) présente un filtre passe-bas (18) qui est connecté en série en aval de l'amplificateur de puissance (3), et le signal d'entrée (20) du filtre passe-bas (18) est le signal de sortie amplifié (20) généré par l'amplificateur de puissance (3).

11. Dispositif (1) selon la revendication 10, dans lequel le dispositif de combinaison (7) présente un soustracteur (38), disposé en aval des deux multiplicateurs (36, 37), qui est conçu pour former une différence entre le carré de la partie réelle (8) et le carré de la partie imaginaire (9) de sorte que soit généré un signal de sortie numérique de valeur réelle (39).

12. Dispositif selon la revendication 11, dans lequel le dispositif de combinaison (7) présente un comparateur (44) connecté en série en aval du soustracteur (38) et un convertisseur numérique-analogique (40) disposé entre le soustracteur (38) et le comparateur (44), dans lequel le convertisseur numérique-analogique (40) est conçu pour convertir le signal de sortie numérique de valeur réelle (39) du soustracteur (38) en un signal analogique (43), et dans lequel le comparateur (44) est conçu pour convertir le signal de sortie analogique (43) du convertisseur numérique-analogique (40) en un signal d'entrée binaire (4) de l'amplificateur de puissance (3).

13. Dispositif (1) selon la revendication 10, dans lequel le dispositif de combinaison (7) présente un soustracteur (38), connecté en aval des deux multiplicateurs (36, 37), qui est conçu pour former une différence entre le carré de la partie réelle (8) et le carré de la partie imaginaire (9) de sorte que soit généré un signal de sortie analogique de valeur réelle (39).

14. Dispositif selon la revendication 13, dans lequel le dispositif de combinaison (7) présente un comparateur (44) connecté en série en aval du soustracteur (38), dans lequel le comparateur (44) est conçu pour convertir le signal de sortie analogique (39) en signal d'entrée binaire (4) de l'amplificateur de puissance (3).

15. Dispositif (1) selon l'une des revendications précédentes, dans lequel le dispositif d'addition (6) présente un premier additionneur (11) et un deuxième additionneur (12), dans lequel le premier additionneur (11) est conçu pour combiner la partie réelle (21) du signal d'entrée (2) avec la partie réelle (13) du signal porteur (13, 14) pour obtenir une partie réelle (8) du signal résultant (8, 9), et dans lequel le deuxième additionneur (12) est conçu pour combiner la partie imaginaire (22) du signal d'entrée (2) avec la partie imaginaire (14) du signal porteur (13, 14) pour obtenir une partie imaginaire (9) du signal résultant (8, 9).

16. Procédé d'amplification d'un signal d'entrée (2) aux étapes suivantes consistant à :

    amplifier un signal d'entrée binaire (4) de de sorte que soit généré un signal de sortie amplifié (20),
    générer du signal d'entrée binaire (4) sur base du signal d'entrée (2), où le signal d'entrée (2) est un signal d'entrée de valeur complexe et le signal d'entrée binaire (4) est un signal de valeur réelle,
    additionner le signal d'entrée de valeur complexe (2) avec un signal porteur de valeur complexe (13, 14) d'une fréquence prédéterminée ($f_c$) pour générer un signal de valeur complexe résultant (8, 9), et
    générer le signal d'entrée binaire de valeur réelle (4) à partir de la partie réelle (8) et de la partie imaginaire (9) du signal de valeur complexe résultant (8, 9) en multipliant la partie réelle (8) et la partie imaginaire (9) du signal de valeur complexe résultant (8, 9) et amener le signal de valeur complexe résultant (8, 9) à un comparateur connecté en aval (16), et
    filtrer passe-bas le signal de sortie amplifié généré (20) pour éliminer par filtrage la partie de signal de bande extérieure du signal de sortie amplifié (20).

17. Procédé selon la revendication 16, dans lequel le signal d'entrée de valeur complexe (2) est un signal analogique et dans lequel la multiplication de la partie réelle (8) et de la partie imaginaire (9) du signal analogique de valeur complexe résultant (8, 9) résulte en un signal analogique combiné (17), et dans lequel ce signal analogique combiné (17) est converti au moyen du comparateur (16) en signal d'entrée binaire continu dans le temps (4) de l'amplificateur de puissance (3).

18. Procédé selon la revendication 16, dans lequel le signal d'entrée de valeur complexe (2) est un signal numérique et dans lequel la partie réelle (8) et la partie imaginaire (9) sont combinées par la multiplication en un signal de sortie numérique (17), dans lequel le signal de sortie numérique (17) est converti, après la multiplication, en signal analogique (25), et dans lequel le signal analogique (25) est converti au moyen du comparateur (16) en signal d'entrée binaire continu dans le temps (4) de l'amplificateur de puissance (3).

19. Procédé d'amplification d'un signal d'entrée (2) aux étapes suivantes consistant à :

    amplifier un signal d'entrée binaire (4) de sorte que soit généré un signal de sortie amplifié (20),
    générer le signal d'entrée binaire (4) sur base du signal d'entrée (2), où le signal d'entrée (2) est un signal d'entrée de valeur complexe et le signal d'entrée binaire (4) est un signal de valeur réelle,
    additionner le signal d'entrée de valeur complexe (2) avec un signal porteur de valeur complexe (13, 14) d'une fréquence prédéterminée ($f_c$) pour générer un signal de valeur complexe résultant (8, 9), et
    générer le signal d'entrée binaire de valeur réelle (4) à partir de la partie réelle (8) et de la partie imaginaire (9) du signal de valeur complexe résultant (8, 9) par une combinaison de la partie réelle (8) et de la partie imaginaire (9) du signal de valeur complexe résultant (8, 9), où la partie réelle (8) est traitée au moyen d'un premier comparateur (33) et la partie imaginaire (9) est traitée au moyen d'un deuxième comparateur (34) et combinées dans une grille XOR (35) connectée en série en aval, et

filtrer passe-bas le signal de sortie amplifié généré (20) pour éliminer par filtrage la partie de signal de bande extérieure du signal de sortie amplifié (20).

20. Procédé pour amplifier un signal d'entrée (2) aux étapes suivantes consistant à:

amplifier un signal d'entrée binaire (4) de sorte que soit généré un signal de sortie amplifié (20),

générer le signal d'entrée binaire (4) sur base du signal d'entrée (2), où le signal d'entrée (2) est un signal d'entrée de valeur complexe et le signal d'entrée binaire (4) est un signal de valeur réelle,

additionner le signal d'entrée de valeur complexe (2) avec un signal porteur de valeur complexe (13, 14) d'une fréquence prédéterminée ($f_c$) pour générer un signal de valeur complexe résultant (8, 9),

dans lequel, après l'addition, un signal de sortie discret dans le temps (8) formé à partir de la partie réelle est multiplié par lui-même dans le temps et, après l'addition, un signal de sortie discret dans le temps (9) formé à partir de la partie imaginaire est multiplié par lui-même dans le temps,

générer le signal d'entrée binaire de valeur réelle (4) à partir de la partie réelle (8) multipliée par elle-même et de la partie imaginaire multipliée par elle-même (9) du signal de valeur complexe résultant (8, 9) par une combinaison de la partie réelle multipliée par elle-même (8) et de la partie imaginaire multipliée par elle-même (9) du signal de valeur complexe résultant (8, 9), et

filtrer passe-bas le signal de sortie amplifié généré (20) pour éliminer par filtrage la partie de signal de bande extérieure du signal de sortie amplifié (20).

21. Procédé selon la revendication 20, dans lequel la partie réelle multipliée par elle-même (8) et la partie imaginaire multipliée par elle-même (9) sont soustraites pour obtenir une différence entre le carré de la partie réelle (8) et le carré de la partie imaginaire (9), de sorte que soit généré un signal de sortie numérique de valeur réelle (39).

22. Procédé selon la revendication 20, dans lequel la partie réelle multipliée par elle-même (8) et la partie imaginaire multipliée par elle-même (9) sont soustraites pour obtenir une différence entre le carré de la partie réelle (8) et le carré de la partie imaginaire (9), de sorte que soit généré un signal de sortie analogique de valeur réelle (39).

Fig. 1

EP 3 076 544 B1

Fig. 2

Fig. 3

Fig. 4

Fig. 5

EP 3 076 544 B1

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2498397 A1